(19) Europäisches Patentamt
European Patent Office
Office européen des brevets

(11) **EP 2 039 474 A1**

(12) **EUROPEAN PATENT APPLICATION**
published in accordance with Art. 153(4) EPC

(43) Date of publication:
**25.03.2009 Bulletin 2009/13**

(51) Int Cl.:
**B24B 37/00** (2006.01)   **C09K 3/14** (2006.01)
**H01L 21/304** (2006.01)

(21) Application number: **08711161.3**

(22) Date of filing: **13.02.2008**

(86) International application number:
**PCT/JP2008/052303**

(87) International publication number:
**WO 2008/102672 (28.08.2008 Gazette 2008/35)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **20.02.2007 JP 2007039584**

(71) Applicant: **Sumitomo Electric Industries, Ltd. Osaka-shi, Osaka 541-0041 (JP)**

(72) Inventors:
• **KAWABATA, Kazuhiro**
  **Osaka-shi**
  **Osaka 554-0024 (JP)**
• **NAKAYAMA, Shigeyoshi**
  **Osaka-shi**
  **Osaka 554-0024 (JP)**
• **ISHIBASHI, Keiji**
  **Osaka-shi**
  **Osaka 554-0024 (JP)**

(74) Representative: **Grünecker, Kinkeldey, Stockmair & Schwanhäusser Anwaltssozietät Leopoldstrasse 4 80802 München (DE)**

(54) **POLISHING SLURRY, METHOD FOR MANUFACTURING THE POLISHING SLURRY, NITRIDE CRYSTALLINE MATERIAL AND METHOD FOR POLISHING SURFACE OF THE NITRIDE CRYSTALLINE MATERIAL**

(57)   The invention offers a slurry for polishing the surface of a nitride crystal. The polishing slurry contains oxide abrasive grains, at least one dispersant selected from the group consisting of an anionic organic dispersant and an inorganic dispersant, and an oxidizing reagent. The polishing slurry has a pH of less than 7. The slurry efficiently polishes the surface of the nitride crystal.

FIG. 2

**Description**

Technical Field

The present invention relates to a polishing slurry to be used suitably for the polishing of the surface of a nitride crystal and to the production method thereof.

Background Art

The types of nitride-ceramic components to be used, for example, for a sliding part of a motor or the like include sintered bodies composed of $Si_3N_4$ crystals, AlN crystals, TiN crystals, GaN crystals, and so on. In the present invention, the term "a crystal" includes a single crystal and a polycrystal, and hereinafter, the same is applied. These sintered bodies composed of crystals are formed to have an intended shape. The formed body is polished to have a flat, smooth surface. Thus, a sliding part is produced.

The types of crystals for forming a wafer to be used as the substrate of a semiconductor device include an insulating crystal, such as an $SiO_2$ crystal, and a semiconducting crystal, such as a silicon crystal and a nitride crystal. These crystals are all cut to have an intended shape. The cut crystal is polished to have a flat, smooth surface. Thus, a substrate is produced.

For example, the published Japanese patent application *Tokukai* 2003-306669 (Patent literature 1) has proposed a polishing slurry for polishing the surface of an oxide crystal, such as an $SiO_2$ crystal. As the slurry, a polishing slurry is proposed that is composed of water, polishing particles, and a polishing promoter. The polishing promoter is made of organic acid or salt of organic acid, and the slurry is acidic. The published Japanese patent application *Tokukai* 2001-035819 (Patent literature 2) has proposed a polishing slurry for polishing the surface of a silicon crystal. As the slurry, a polishing slurry is proposed in which bonded-body particles each composed of abrasive grains and a binder are dispersed in a liquid.

As for the above-described nitride crystal, however, because the crystal is chemically stable to a great extent, a polishing slurry for efficiently polishing the crystal's surface has not been obtained.

Patent literature 1: the published Japanese patent application *Tokukai* 2003-306669
Patent literature 2: the published Japanese patent application *Tokukai* 2001-035819.

Disclosure of the Invention

Problem to be Solved by the Invention

In view of the above-described present circumstances, an object of the present invention is to offer not only a polishing slurry for efficiently polishing the surface of a nitride crystal and the production method thereof but also a method of polishing the surface of a nitride crystal by using the foregoing polishing slurry

Means to Solve the Problem

The present invention offers a polishing slurry for polishing the surface of a nitride crystal. The polishing slurry contains oxide abrasive grains, at least one dispersant selected from the group consisting of an anionic organic dispersant and an inorganic dispersant, and an oxidizing reagent. The polishing slurry has a pH of less than 7.

The polishing slurry of the present invention may contain both an anionic organic dispersant and an inorganic dispersant as the dispersant. The oxide abrasive grains may have an isoelectric point higher than the pH of the polishing slurry. The oxide abrasive grains may be composed of at least one type of oxide selected from the group consisting of $Ti_2O$, $Fe_2O_3$, $Fe_3O_4$, $NiO$, $CuO$, $Cr_2O_3$, $SiO_2$, $Al_2O_3$, $MnO_2$, and $ZrO_2$. The anionic organic dispersant may have a -COOM group ("M" stands for H, $NH_4$, or a metallic element). The inorganic dispersant may be at least one member selected from the group consisting of $Ca(NO_3)_2$, $NaNO_3$, $Al(NO_3)_3$, $Mg(NO_3)_2$, $Ni(NO_3)_2$, $Cr(NO_3)_3$, $Cu(NO_3)_2$, $Fe(NO_3)_2$, $Zn(NO_3)_2$, $Mn(NO_3)_2$, $Na_2SO_4$, $Al_2(SO_4)_3$, $MgSO_4$, $NiSO_4$, $Cr_2(SO_4)_3$, $CuSO_4$, $FeSO_4$, $ZnSO_4$, $MnSO_4$, $Na_2CO_3$, $NaHCO_3$, $Na_3PO_4$, $CaCl_2$, $NaCl$, $AlCl_3$, $MgCl_2$, $NiCl_2$, $CuCl_2$, $FeCl_2$, $ZnCl_2$, and $MnCl_2$.

The present invention offers a method of producing the above-described polishing slurry. The method is provided with the following steps:

(a) first, adding to an aqueous liquid at least the oxide abrasive grains and at least one dispersant selected from the group consisting of the anionic organic dispersant and the inorganic dispersant, and
(b) then, mechanically dispersing the oxide abrasive grains.

The present invention offers a method of polishing the surface of a nitride crystal. The method performs the polishing of the surface of the nitride crystal chemomechanically by using the above-described polishing slurry.

The present invention offers a nitride crystal that is obtained through the above-described surface-polishing method and that has a surface roughness, Ra, of at most 2 nm.

Effect of the Invention

The present invention can offer not only a polishing slurry for efficiently polishing the surface of a nitride crystal and the production method thereof but also a method of polishing the surface of a nitride crystal by using the foregoing polishing slurry.

Brief Description of the Drawing

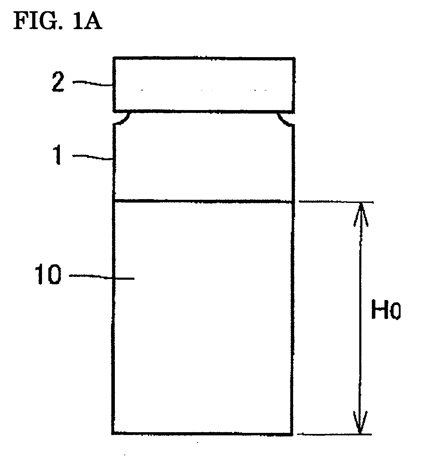

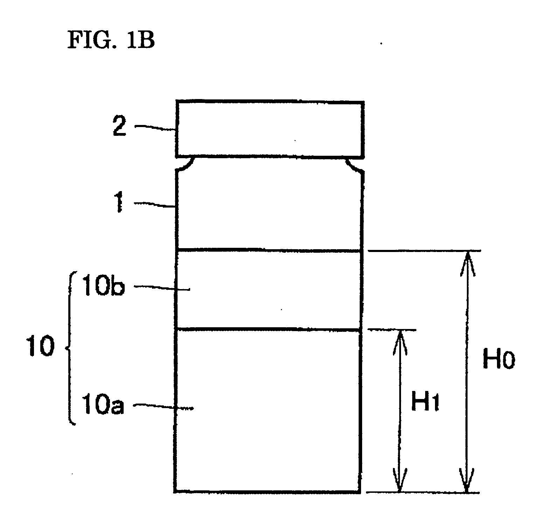

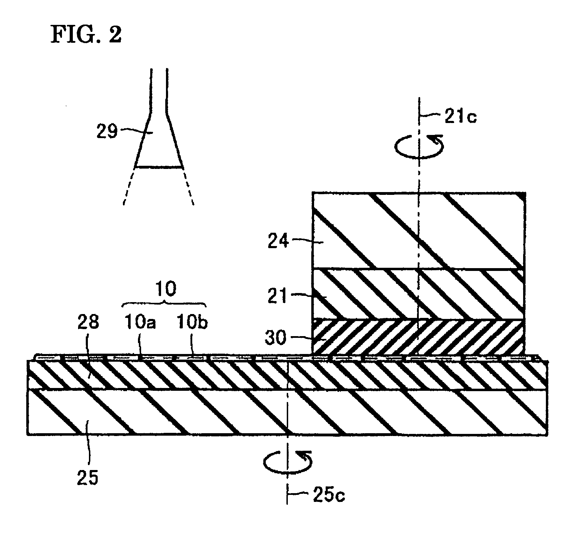

Figure 1A is a schematic diagram explaining the method of evaluating the dispersibility of the abrasive grains in the polishing slurry, the diagram showing the state of the polishing slurry directly after the shaking of the sample bottle. Figure 1B is a schematic diagram explaining the method of evaluating the dispersibility of the abrasive grains in the polishing slurry, the diagram showing the state of the polishing slurry after maintaining the sample bottle standstill. Figure 2 is a schematic cross-sectional view showing the method of polishing polycrystal, which is a III-group nitride, or single-crystal $Si_3N_4$ by using the polishing slurry.

Explanation of the Sign

1: Sample bottle
2: Lid
10: Polishing slurry
10a: Phase in which oxide abrasive grains are present
10b: Phase in which no oxide abrasive grains are present
21: Crystal holder
21c and 25c: Axis of rotation
24: Weight
25: Surface plate
28: Polishing pad
29: Polishing-slurry-feeding outlet
30: Nitride crystal

Best Mode for Carrying Out the Invention

Embodiments of the present invention are explained below. In the explanation of the drawing, the same element bears the same sign to avoid duplicated explanations. The ratios of the dimensions in the drawing are not necessarily coincident with those of the explanation.

A polishing slurry of the present invention is a slurry for polishing the surface of a nitride crystal. The slurry contains oxide abrasive grains, at least one dispersant selected from the group consisting of an anionic organic dispersant and an inorganic dispersant, and an oxidizing reagent. The slurry has a pH of less than 7. In the polishing slurry of the present invention, the oxide abrasive grains are stably dispersed by at least one dispersant selected from the group consisting of an anionic organic dispersant and an inorganic dispersant. The above-described oxide abrasive grains and the oxidizing reagent together enable the stable performing of an efficient polishing.

As described above, the polishing slurry of the present invention can have the following three types of embodiments depending on the type of the dispersant used:

(a) a case where the dispersant is an anionic organic dispersant,
(b) a case where the dispersant is an inorganic dispersant, and
(c) a case where the dispersant is composed of both an anionic organic dispersant and an inorganic dispersant.

The individual embodiments are concretely explained below.

EMBODIMENT 1

One embodiment of the polishing slurry of the present invention is a slurry for polishing the surface of a nitride crystal. The slurry contains oxide abrasive grains, an anionic organic dispersant, and an oxidizing reagent and has a pH of less than 7. In the present invention, the nitride crystal has no particular limitation provided that the nitride is a crystalline nitride. For example, the types of the nitride crystal include both a nitride single crystal and a nitride polycrystal.

The polishing slurry of this embodiment contains oxide abrasive grains and an oxidizing reagent and has a pH of less than 7. Consequently, it can polish the surface of a chemically stable nitride crystal by oxidizing the surface. More specifically, the surface of the nitride crystal is oxidized by the oxidizing reagent existing in an acidic liquid having a pH of less than 7. Then, the oxidized portion is polished by the oxide abrasive grains.

In the above description, the term "an oxidizing reagent" is used to mean a compound that oxidizes the surface of the nitride crystal. The oxidizing reagent has no particular limitation. Nevertheless, from the view point of increasing the polishing rate, it is desirable to use chlorinated isocyanuric acid, such as trichloroisocyanuric acid; chlorinated isocyanurate, such as sodium dichloroisocyanurate and sodium trichloroisocyanurate; permanganate, such as potassium permanganate; dichromate, such as potassium dichromate; bromate, such as potassium bromate; thiosulphate, such as sodium thiosulphate; persulphate, such as ammonium persulphate and potassium persulphate; hypochlorous acid; nitric acid; hydrogen peroxide water; ozone; and so on. These oxidizing reagents may be used either singly or in a combination of two or more reagents.

The content of the oxidizing reagent in the polishing slurry depends on the type of the oxidizing reagent. The content has no particular limitation. Nevertheless, it is desirable that the content be at least 0.01 wt. % and at most 5 wt. %, more desirably at least 0.05 wt. % and at most 1 wt. % in order to promote the oxidation of the surface of the nitride crystal, to suppress the corrosion of the polishing apparatus (polishing apparatus, polishing pad, and so on, and hereinafter the same is applied), and consequently to perform a stable polishing.

The term "oxide abrasive grains" is used to mean abrasive grains formed of oxides. The surface of the oxide abrasive grains is the place where a large quantity of hydroxyl groups are present. In the case where such oxide abrasive grains are dispersed in an aqueous liquid, when the aqueous liquid is acidic, hydrogen ions in the liquid bond with the hydroxyl groups on the surface of the abrasive grains, positively charging the surface of the abrasive grains. On the other hand, when the aqueous liquid is basic, hydroxide ions in the liquid extract hydrogen ions from the hydroxyl groups on the surface of the abrasive grains, negatively charging the surface of the abrasive grains. The term "an aqueous liquid" is used to mean a liquid containing a solvent composed mainly of water.

In the polishing slurry of this embodiment, the oxide abrasive grains are stably dispersed by the anionic organic dispersant. Because the polishing slurry is acidic with a pH of less than 7, the oxide abrasive grains tend to be positively charged. Consequently, the electrostatic attraction with the anionic organic dispersant increases the dispersibility in the aqueous liquid.

The oxide abrasive grains have no particular limitation. Nevertheless, it is desirable that the oxide abrasive grains have an isoelectric point higher than the pH of the polishing slurry. The term "an isoelectric point" means a point at which the algebraic summation of the electric charges of the oxide abrasive grains in the polishing slurry becomes zero. In other words, at that point, the positive charges and the negative charges assumed by the oxide abrasive grains become equal. The point is expressed as the pH of the polishing slurry. When the oxide abrasive grains have an isoelectric point higher than the pH of the polishing slurry, the oxide abrasive grains in the slurry are positively charged without exception. Therefore, the electrostatic attraction with the anionic organic dispersant further increases the dispersibility of the oxide abrasive grains in the aqueous liquid, enabling the performing of a more stable polishing.

The oxide for forming the oxide abrasive grains has no particular limitation. Nevertheless, it is desirable that the oxide have a Mohs' hardness higher than that of the nitride crystal in order to increase the efficiency of the polishing. However, it is desirable that the oxide have a Mohs' hardness lower than that of the nitride crystal in order to suppress polishing flaws. It is desirable that the oxide be composed of at least one member selected from the group consisting of, for example, $TiO_2$, $Fe_2O_3$, $Fe_3O_4$, $NiO$, $CuO$, $Cr_2O_3$, $MnO_2$, $SiO_2$, $Al_2O_3$, and $ZrO_2$. The members of the foregoing group have the following isoelectric points:

$TiO_2$: 4.8 to 6.7
$Fe_2O_3$ ($\alpha$ $Fe_2O_3$ usually used as a material for abrasive grains): 8.3
$FeaO_4$: 6.5
$NiO$: 10.3
$CuO$: 9.5
$Cr_2O_3$: 6.5 to 7.4
$MnO_2$: 6.0 to 8.4
$SiO_2$: 1 to 2.8
$Al_2O_3$ ($\alpha$ - $Al_2O_3$ usually used as a material for abrasive grains): 9.1 to 9.2

ZrO$_2$: 4.

It is desirable that these oxide abrasive grains be dispersed in a polishing slurry having a pH lower than the isoelectric point of them.

It is desirable that the content of the oxide abrasive grains in the polishing slurry be at least 1 wt. % and at most 20 wt. %, more desirably at least 5 wt. % and at most 10 wt. % in order to promote the polishing of the surface of the nitride crystal, to suppress the formation of polishing flaws, and consequently to perform a stable polishing.

It is desirable that the oxide abrasive grains have a Mohs' hardness that has a difference of at most 3 from that of the nitride crystal to be polished in order to suppress polishing flaws while maintaining a high polishing rate. In addition, it is desirable that the oxide abrasive grains have an average grain diameter of at least 0.1 $\mu$m and at most 3 $\mu$m, more desirably at least 0.4 $\mu$m and at most 1 $\mu$m in order to promote the polishing of the surface of the nitride crystal, to suppress the formation of polishing flaws, and consequently to perform a stable polishing.

In the polishing slurry of this embodiment, the anionic organic dispersant has no particular limitation. For example, the types of anionic organic dispersant include anionic organic compounds having a group, such as a -COOM group ("M" stands for H, NH$_4$, or a metallic element, and hereinafter the same is applied), a -COO- group, an -SO$_3$M group, an -OSO$_3$M group, an (-O)$_2$S=O group, an -OPOOM group, an (-O)$_2$PO(OM)$_2$ group, or an (-O)$_3$PO group. It is desirable that the anionic organic dispersant have a -COOM group because when this condition is met, the dispersant has a negative charge, thereby increasing the dispersibility of the oxide abrasive grains. For example, it is desirable that the anionic organic dispersant have polyacrylic acid or its salt. It is desirable that the anionic organic dispersant in the polishing slurry have an average molecular weight of at least 1,000 and at most 50,000, more desirably at least 2,000 and at most 35,000 in order to increase the dispersibility of the oxide abrasive grains while maintaining a high polishing rate and to perform a stable polishing. The content of the anionic organic dispersant in the polishing slurry depends on the type, content, and so on of the oxide abrasive grains. Nevertheless, it is desirable that the content be at least 0.001 wt. % and at most 10 wt. %, more desirably at least 0.01 wt. % and at most 5 wt. % in order to increase the dispersibility of the oxide abrasive grains while maintaining a high polishing rate and to perform a stable polishing.

In addition, it is desirable that the anionic organic dispersant have a plurality of hydrophilic groups and have only a small quantity of hydrophobic groups and that the existing hydrophobic groups have a lateral chain and a branching so that the dispersant can have a low bubbling tendency. When the polishing slurry includes bubbles, not only the dispersibility of the abrasive grains but also the polishing performance is decreased.

It is desirable that in the polishing slurry of this embodiment, the value "x" of its pH and the value "y" of its oxidation-reduction potential (hereinafter abbreviated as ORP) expressed in mV have a relationship expressed by the following equations (1) and (2) in order to increase the polishing rate:

$$y \geqq -50x + 1,000 \qquad\qquad \cdots (1)$$

$$y \leqq -50x + 1,900 \qquad\qquad \cdots (2).$$

In the above description, the term "an ORP" means an energy level (an oxidation-reduction potential) determined by the condition of equilibrium between the oxidant and the reductant coexisting in the solution. The ORP obtained by a measurement is a value with respect to a reference electrode. Consequently, when the type of the reference electrode differs, the measured value even on the same solution differs in appearance. Many general academic papers employ the normal hydrogen electrode (NHE) as the reference electrode. In the present invention, the ORP is shown by the value obtained by using the normal hydrogen electrode (NHE) as the reference electrode.

In the polishing slurry of this embodiment, when the value "x" of its pH and the value "y" (mV) of its ORP have a relationship expressed as y < -50x + 1,000, the polishing slurry has a low oxidizing ability As a result, the polishing rate of the surface of the nitride crystal is decreased. On the other hand, when the relationship is y > -50x + 1,900, the polishing slurry has an excessively high oxidizing ability As a result, a corrosive action is increased on the polishing apparatus, such as the polishing pad and surface plate. Therefore, it becomes difficult to stably perform a chemomechanical polishing (hereinafter abbreviated as CMP).

In addition, to further increase the polishing rate, it is desirable that the relationship further satisfy y $\geqq$ -50x + 1,300. In other words, it is desirable that in the polishing slurry, the value "x" of its pH and the value "y" (mV) of its ORP have a relationship expressed by the following equations (2) and (3):

$$y \leqq -50x + 1{,}900 \qquad \cdots (2)$$

$$y \geqq -50x + 1{,}300 \qquad \cdots (3).$$

The polishing slurry of this embodiment has a pH of less than 7. To increase the polishing rate, it is desirable that the polishing slurry have a pH of less than 3. To regulate its pH, the polishing slurry contains an acid, a base, and a salt (hereinafter referred to as a pH regulator) singly or in combination. The pH regulator for the polishing slurry has no particular limitation. The pH regulator may be composed of, for example, not only an inorganic acid, such as hydrochloric acid, nitric acid, sulfuric acid, phosphoric acid, and carbonic acid; an organic acid, such as methanoic acid, ethanoic acid, citric acid, malic acid, tartaric acid, succinic acid, phthalic acid, and boletic acid; and a base, such as KOH, NaOH, $NH_4OH$, and an amine, but also a salt containing these acids or bases. Furthermore, the pH can also be regulated by adding the above-described oxidizing reagent.

EMBODIMENT 2

Another embodiment of the polishing slurry of the present invention is a slurry for polishing the surface of a nitride crystal. The slurry contains oxide abrasive grains, an inorganic dispersant, and an oxidizing reagent and has a pH of less than 7.

As described above, the polishing slurry of this embodiment is the same as that of Embodiment 1, except that as the dispersant, the anionic organic dispersant is replaced with an inorganic dispersant. In the polishing slurry of this embodiment, under an acidic condition with a pH of less than 7, the inorganic dispersant is solvated by the aqueous liquid in the slurry. Then, the inorganic dispersant is suspended in the slurry to be dispersed. The solvated inorganic dispersant that is suspended and dispersed in the slurry is negatively charged. Consequently, under the acidic condition with a pH of less than 7, the oxide abrasive grains, which are likely to be positively charged, increase their dispersibility in the aqueous liquid with the help of the electrostatic attraction with the negatively charged suspended inorganic dispersant.

The inorganic dispersant to be used in the polishing slurry of this embodiment has no particular limitation provided that the inorganic dispersant can function as a suspendible dispersant under the acidic condition with a pH of less than 7. Nevertheless, it is desirable to use nitrates, sulfates, phosphates, chlorides, and so on because they have high suspendibility and dispersibility in the slurry. For example, it is desirable that the inorganic dispersant be at least one member selected from the group consisting of $Ca(NO_3)_2$, $NaNO_3$, $Al(NO_3)_3$, $Mg(NO_3)_2$, $Ni(NO_3)_2$, $Cr(NO_3)_3$, $Cu(NO_3)_2$, $Fe(NO_3)_2$, $Zn(NO_3)_2$, $Mn(NO_3)_2$, $Na_2SO_4$, $Al_2(SO_4)_3$, $MgSO_4$, $NiSO_4$, $Cr_2(SO_4)_3$, $CuSO_4$, $FeSO_4$, $ZnSO_4$, $MnSO_4$, $Na_2CO_3$, $NaHCO_3$, $Na_3PO_4$, $CaCl_2$, $NaCl$, $AlCl_3$, $MgCl_2$ $NiCl_2$, $CuCl_2$, $FeCl_2$, $ZnCl_2$, and $MnCl_2$.

It is desirable that the content of the inorganic dispersant in the polishing slurry of this embodiment be at least 0.001 wt. % and at most 0.5 wt. %, more desirably at least 0.005 wt. % and at most 0.2 wt. % in order to increase the dispersibility of the metallic oxide abrasive grains while maintaining a high polishing rate and to perform a stable polishing.

In this embodiment, the oxide abrasive grains and oxidizing reagent used in the polishing slurry and the pH of the polishing slurry are the same as those of Embodiment 1.

EMBODIMENT 3

Yet another embodiment of the polishing slurry of the present invention is a slurry for polishing the surface of a nitride crystal. The slurry contains oxide abrasive grains, an anionic organic dispersant, an inorganic dispersant, and an oxidizing reagent and has a pH of less than 7.

Because the polishing slurry of this embodiment contains both an anionic organic dispersant and an inorganic dispersant as the dispersant for the oxide abrasive grains, the polishing slurry differs both from the polishing slurry of Embodiment 1, which contains an anionic organic dispersant as the dispersant, and from the polishing slurry of Embodiment 2, which contains an inorganic dispersant as the dispersant. Because the polishing slurry of this embodiment contains both an anionic organic dispersant and an inorganic dispersant as the dispersant for the oxide abrasive grains, the interaction between the two types of dispersant further increases the dispersibility of the oxide abrasive grains.

More specifically, in Embodiment 1, the positive charge given to the oxide abrasive grains is canceled out by the negative charge of the anionic organic dispersant. Consequently, the electrostatic repulsion between the oxide abrasive grains is decreased, so that the sinking of the oxide abrasive grains is prone to occur due to the flocculation of the grains. On the other hand, in this embodiment, the inorganic dispersant, which acts as a suspendible dispersant, retards the sinking of the oxide abrasive grains, further increasing the dispersibility of the oxide abrasive grains. By the same token, in Embodiment 2, the positive charge given to the oxide abrasive grains is canceled out by the negative charge of the inorganic dispersant. Consequently, the electrostatic repulsion between the oxide abrasive grains is decreased, so that the flocculation of the oxide abrasive grains is prone to occur. On the other hand, in this embodiment, the electrostatic repulsion caused by the negative charge possessed by the anionic organic dispersant suppresses the flocculation of the oxide abrasive grains, further increasing the dispersibility of the oxide abrasive grains.

In the polishing slurry of this embodiment, the oxide abrasive grains, the anionic organic dispersant, the oxidizing reagent, and the pH are the same as those of Embodiment 1 and the inorganic dispersant is the same as that of Embodiment 2.

Yet another embodiment of the polishing slurry of the present invention has the same oxide abrasive grains, dispersant, oxidizing reagent, and pH as those of one of the above-described three embodiments. In addition, the polishing slurry in this embodiment further contains boehmite as a sinking retarder. Because the polishing slurry further contains boehmite as a sinking retarder, the viscosity and the volume of the solid bodies are increased. As a result, the dispersibility of the polishing slurry can be increased and the viscosity can become controllable. It is desirable that the polishing slurry have a boehmite content of at least 0.1 wt. % and less than 8 wt. %, more desirably at least 1 wt. % and at most 3 wt. % in order to increase the dispersibility of the polishing slurry and to produce a polishing slurry that suppresses an excessive increase in the viscosity.

Embodiment 4

One embodiment of the method of the present invention for producing a polishing slurry is a production method of the polishing slurries of Embodiments 1 to 3. The production method has steps of, first, adding to an aqueous liquid at least the oxide abrasive grains and at least one of the anionic organic dispersant and the inorganic dispersant and, then, mechanically dispersing the oxide abrasive grains. The mechanical and forced dispersion of the oxide abrasive grains in an aqueous liquid not only decreases the grain diameter of the oxide abrasive grains in the polishing slurry but also enhances the electrostatic coupling between the oxide abrasive grains and the anionic organic dispersant, the inorganic dispersant, or both. As a result, the dispersion of the oxide abrasive grains is stabilized to suppress their flocculation.

The method of mechanically dispersing the oxide abrasive grains has no particular limitation. Nevertheless, it is desirable to use a method of mechanically dispersing the oxide abrasive grains by placing in a bead mill or the like an aqueous liquid containing at least the oxide abrasive grains and at least one of the anionic organic dispersant and the inorganic dispersant. When the aqueous liquid containing at least the oxide abrasive grains and at least one of the anionic organic dispersant and the inorganic dispersant is placed in a bead mill or the like and then the oxide abrasive grains are mechanically and forcefully dispersed in the aqueous liquid, the grain diameter of the oxide abrasive grains in the polishing slurry is decreased and the electrostatic coupling between the oxide abrasive grains and the anionic organic dispersant, the inorganic dispersant, or both is enhanced. As a result, the dispersion of the oxide abrasive grains is stabilized to suppress their flocculation.

The beads to be used in the bead mill have no particular limitation. Nevertheless, it is desirable that the beads be hard beads made of $ZrO_2$, $Al_2O_3$, $TiO_2$, $SiO_2$, $Si_3N_4$, or the like and that the beads have a diameter of 100 $\mu$m to 10 mm or so in order to increase the dispersibility of the oxide abrasive grains. The treatment for mechanically dispersing the oxide abrasive grains by using the bead mill (the treatment is referred to as a mechanical dispersion treatment) may be performed at any time provided that the time is after at least the oxide abrasive grains and at least one of the anionic organic dispersant and the inorganic dispersant are added to the aqueous liquid.

The surface-polishing method of this embodiment can efficiently produce a nitride crystal having a surface roughness, Ra, of at most 2 nm. The surface roughness Ra is a value obtained by the following procedure. First, an average plane is determined using a roughness curved surface. Next, only a specified reference area is sampled from the roughness curved surface. In the sampled region, the absolute values of the individual deviations from the average plane to the curved surface to be measured are summed. The summed value is divided by the reference area to obtain the average value, which is the surface roughness Ra. The surface roughness Ra can be measured by using an optical roughness meter, a step displacement meter, an atomic force microscope (AFM), or the like.

Examples

Example 1

(a) Preparation of a polishing slurry

A slurry was prepared by adding to water 5 wt. % $Al_2O_3$ abrasive grains having an average grain diameter of

2.5 $\mu$m as oxide abrasive grains and 0.1 wt. % polyacrylic acid sodium (hereinafter referred to as PAA) having a number average molecular weight of 2,000 as an anionic organic dispersant. The slurry was placed in a bead mill provided with beads, made by Nikkato Corp. (Japan), having an average diameter of 500 $\mu$m. The slurry was subjected to a mechanical dispersion treatment for the abrasive grains for five hours at a revolution rate of 100 rpm. The slurry subjected to the mechanical dispersion treatment was augmented by adding to it 0.2-g/L dichloroisocyanuric acid sodium (hereinafter referred to as DCIA) as the oxidizing reagent and malic acid as the pH regulator. (In the above description, the unit "g/L" is used to mean the number of grams included in a liter of slurry, and hereinafter the same is applied.) Then, the added ingredients were mixed. Thus, a polishing slurry was obtained that contained abrasive grains having an average grain diameter of 1 $\mu$m, had a pH of 5, and had an ORP of 1,200 mV The average grain diameter of the abrasive grains was measured with a particle-size distribution meter.

(b) Evaluation of dispersibility of the oxide abrasive grains in the polishing slurry

As shown in Fig. 1A, a polishing slurry 10 that was prepared as described in (a) above and that had a volume of 30 cm$^3$ was placed in a sample bottle 1 having a capacity of 50 cm$^3$. Then, a lid 2 was placed. The sample bottle 1 was shaken for at least one minute. It was visually confirmed that the oxide abrasive grains were uniformly dispersed in the polishing slurry 10. The sample bottle was maintained standstill for three hours at room temperature (for example, at 25°C). At this moment, as shown in Fig. 1B, the polishing slurry was separated into two phases; one was a phase 10a in which sunken oxide abrasive grains are present and the other was a phase 10b in which no oxide abrasive grains are present. The dispersibility (%) of the oxide abrasive grains in the polishing slurry is calculated using the following equation (4):

$$\text{Dispersibility (\%)} = 100 \times H_1/H_0 \qquad \cdots \ (4),$$

where $H_0$: height of the polishing slurry 10 in the sample bottle 1, and
$H_1$: height of the phase 10a in which sunken oxide abrasive grains are present.

As described below, when the dispersibility calculated by using the above equation is less than 20% (when the quantity of the abrasive grains is 5 wt. %), it becomes difficult to stably polish the nitride crystal due to the sinking of the abrasive grains. The dispersibility of the oxide abrasive grains in the polishing slurry of Example 1 was 17%.

(c) Test of the polishing of a nitride crystal using the polishing slurry

Figure 2 shows a method of performing the CMP on the surface of a nitride crystal 30, which is an $Si_3N_4$ polycrystal, by using the polishing slurry 10 obtained as explained in (a) above. The CMP was performed as described below. First, the $Si_3N_4$ polycrystal (the nitride crystal 30) was attached to a ceramic crystal holder 21 with wax.

Next, a polishing pad 28 was placed on a surface plate 25, having a diameter of 300 mm, provided in a polishing apparatus (not shown). The polishing slurry 10, containing the dispersed oxide abrasive grains, was fed to the polishing pad 28 from a polishing-slurry-feeding outlet 29. While the polishing slurry 10 was being fed, the polishing pad 28 was rotated around an axis of rotation 25c. Concurrently, a weight 24 was placed on the crystal holder 21 to press the $Si_3N_4$ polycrystal (the nitride crystal 30) to the polishing pad 28. While this condition was being maintained, the $Si_3N_4$ polycrystal (the nitride crystal 30) was rotated around an axis of rotation 21c of the crystal holder 21. Thus, the CMP of the surface of the $Si_3N_4$ polycrystal was performed.

In the above description, the polishing pad 28 was formed of a polyurethane buffing pad (Supreme RN-R, made by Nitta Haas Inc. (Japan)). The surface plate 25 was a stainless-steel surface plate. The polishing pressure was 200 to 1,000 g/cm$^2$. The number of revolutions for the $Si_3N_4$ polycrystal (the nitride crystal 30) and the polishing pad 28 was 20 to 90 rpm for both of them. The polishing duration was 180 minutes.

The polishing rate of the $Si_3N_4$ polycrystal was calculated by dividing the difference between the thickness of the $Si_3N_4$ polycrystal (the nitride crystal 30) before the polishing and the thickness of it after the polishing by the polishing duration. The calculated polishing rate was as high as 3.7 $\mu$m/hr. The surface roughness Ra of the $Si_3N_4$ polycrystal after the polishing was as extremely low as 1.7 nm. The surface roughness Ra of the $Si_3N_4$ polycrystal after the polishing was measured with an optical roughness meter in a reference area of 80 $\times$ 80 $\mu$m. The results are summarized in Table I.

Example 2

A polishing slurry was prepared by the same method as used in Example 1, except that 0.1 wt. % PAA having a number average molecular weight of 6,000 was added as the anionic organic dispersant. Then, the evaluation of dispersibility of the oxide abrasive grains and the CMP of an $Si_3N_4$ polycrystal were performed. The polishing slurry of Example 2 had abrasive grains with an average grain diameter of 1 $\mu$m, a pH of 5, and an ORP of 1,200 mV The dispersibility of the oxide abrasive grains was 25%. The polishing rate for the $Si_3N_4$ polycrystal was as high as 3.3 $\mu$m/hr. The surface roughness Ra of the $Si_3N_4$ polycrystal after the polishing was as extremely low as 1.4 nm. The results are summarized in Table I.

Example 3

A polishing slurry was prepared by the same method as used in Example 1, except that 0.2 wt. % $Al(NO_3)_3$ was further added as an inorganic dispersant. Then, the evaluation of dispersibility of the oxide abrasive grains and the CMP of an $Si_3N_4$ polycrystal were performed. The polishing slurry of Example 3 had abrasive grains with an average grain diameter of 1 $\mu$m, a pH of 4, and an ORP of 1,250 mV The dispersibility of the oxide abrasive grains was 22%. The polishing rate for the $Si_3N_4$ polycrystal was as high as 3.1 $\mu$m/hr. The surface roughness Ra of the $Si_3N_4$ polycrystal after the polishing was as extremely low as 1.2 nm. The results are summarized in Table I.

Example 4

A polishing slurry was prepared by the same method as used in Example 3, except that 0.1 wt. % PAA having a number average molecular weight of 6,000 was added as the anionic organic dispersant. Then, the evaluation of dispersibility of the oxide abrasive grains and the CMP of an $Si_3N_4$ polycrystal were performed. The polishing slurry of Example 4 had abrasive grains with an average grain diameter of 1 $\mu$m, a pH of 4, and an ORP of 1,250 mV The dispersibility of the oxide abrasive grains was 31%. The polishing rate for the $Si_3N_4$ polycrystal was as high as 2.8 $\mu$m/hr. The surface roughness Ra of the $Si_3N_4$ polycrystal after the polishing was as extremely low as 1.1 nm. The results are summarized in Table I.

Example 5

A polishing slurry was prepared by the same method as used in Example 3, except that 0.1 wt. % PAA having a number average molecular weight of 10,000 was added as the anionic organic dispersant. Then, the evaluation of dispersibility of the oxide abrasive grains and the CMP of an $Si_3N_4$ polycrystal were performed. The polishing slurry of Example 5 had abrasive grains with an average grain diameter of 1 $\mu$m, a pH of 4.5, and an ORP of 1,150 mV. The dispersibility of the oxide abrasive grains was 39%. The polishing rate for the $Si_3N_4$ polycrystal was as high as 2.4 $\mu$m/hr. The surface roughness Ra of the $Si_3N_4$ polycrystal after the polishing was as extremely low as 1.0 nm. The results are summarized in Table I.

Example 6

A polishing slurry was prepared by the same method as used in Example 3, except that a 0.1 wt. % condensation product of naphthalenesulfonic acid having a number average molecular weight of 5,000 and formalin (hereinafter the condensation product is referred to as NSH) was added as the anionic organic dispersant. Then, the evaluation of dispersibility of the oxide abrasive grains and the CMP of an $Si_3N_4$ polycrystal were performed. The polishing slurry of Example 6 had abrasive grains with an average grain diameter of 1 $\mu$m, a pH of 4.5, and an ORP of 1,150 mV The dispersibility of the oxide abrasive grains was as high as 29%. The polishing rate for the $Si_3N_4$ polycrystal was 2.9 $\mu$m/hr. The surface roughness Ra of the $Si_3N_4$ polycrystal after the polishing was as extremely low as 1.2 nm. The results are summarized in Table I.

Example 7

A polishing slurry was prepared by the same method as used in Example 3, except that a 0.1 wt. % NSH having a number average molecular weight of 10,000 was added as the anionic organic dispersant. Then, the evaluation of dispersibility of the oxide abrasive grains and the CMP of an $Si_3N_4$ polycrystal were performed. The polishing slurry of Example 7 had abrasive grains with an average grain diameter of 1 $\mu$m, a pH of 4.5, and an ORP of 1,150 mV. The dispersibility of the oxide abrasive grains was as high as 40%. The polishing rate for the $Si_3N_4$ polycrystal was 2.2 $\mu$m/hr. The surface roughness Ra of the $Si_3N_4$ polycrystal after the polishing was as extremely low as 1.1 nm. The results are summarized in Table I.

Example 8

A polishing slurry was prepared by the same method as used in Example 3, except that 0.1 wt. % hexadecyltriphosphate ester (hereinafter referred to as HDTP) having a number average molecular weight of 805 was added as the anionic organic dispersant. Then, the evaluation of dispersibility of the oxide abrasive grains and the CMP of an $Si_3N_4$ polycrystal were performed. The polishing slurry of Example 8 had abrasive grains with an average grain diameter of 1 $\mu$m, a pH of 4.5, and an ORP of 1,150 mV The dispersibility of the oxide abrasive grains was as low as 12%. The polishing rate for the $Si_3N_4$ polycrystal was 1.2 $\mu$m/hr. The surface roughness Ra of the $Si_3N_4$ polycrystal after the polishing was as extremely low as 1.3 nm. The results are summarized in Table I.

Example 9

A polishing slurry was prepared by the same method as used in Example 3, except that 0.1 wt. % hexadecyltrimethylammonium chloride (hereinafter referred to as HDTMAC), which is a cationic organic dispersant, having a number average molecular weight of 320 was added in place of PAA, which is an anionic organic dispersant. Then, the evaluation of dispersibility of the oxide abrasive grains and the CMP of an $Si_3N_4$ polycrystal were performed. The polishing slurry of Example 9 had abrasive grains with an average grain diameter of 1 $\mu$m, a pH of 4, and an ORP of 1,200 mV The dispersibility of the oxide abrasive grains was 15%. The polishing rate for the $Si_3N_4$ polycrystal was 0.5 $\mu$m/hr. The surface roughness Ra of the $Si_3N_4$ polycrystal after the polishing was as extremely low as 1.4 nm. The results are summarized in Table I.

Example 10

A polishing slurry was prepared by the same method as used in Example 3, except that the pH was changed from 4 to 10. Then, the evaluation of dispersibility of the oxide abrasive grains and the CMP of an $Si_3N_4$ polycrystal were performed. The polishing slurry of Example 10 had abrasive grains with an average grain diameter of 1 $\mu$m, a pH of 10, and an ORP of 1,150 mV The dispersibility of the oxide abrasive grains was as low as 7%. The polishing rate for the $Si_3N_4$ polycrystal was 2.6 $\mu$m/hr. The surface roughness Ra of the $Si_3N_4$ polycrystal after the polishing was as extremely low as 1.9 nm. The results are summarized in Table I.

Comparative example 1

A polishing slurry was prepared by the same method as used in Example 9, except that no inorganic dispersant was added. Then, the evaluation of dispersibility of the oxide abrasive grains and the CMP of an $Si_3N_4$ polycrystal were performed. The polishing slurry of Comparative example 1 had abrasive grains with an average grain diameter of 1 $\mu$m, a pH of 5, and an ORP of 1,100 mV The dispersibility of the oxide abrasive grains was as low as 6%. The polishing rate for the $Si_3N_4$ polycrystal was 0.2 $\mu$m/hr. The surface roughness Ra of the $Si_3N_4$ polycrystal after the polishing was 2.2 nm. The results are summarized in Table I.

Comparative example 2

A polishing slurry was prepared by the same method as used in Comparative example 1, except that 0.1 wt. % polyoxyethylene(10)octyl phenyl ether (hereinafter referred to as POE(10)), which is a nonionic organic dispersant, having a number average molecular weight of 645 was added in place of HDTMAC, which is a cationic organic dispersant. Then, the evaluation of dispersibility of the oxide abrasive grains and the CMP of an $Si_3N_4$ polycrystal were performed. The polishing slurry of Comparative example 2 had abrasive grains with an average grain diameter of 1 $\mu$m, a pH of 5, and an ORP of 1,100 mV The dispersibility of the oxide abrasive grains was as low as 7%. The polishing rate for the $Si_3N_4$ polycrystal was 0.3 $\mu$m/hr. The surface roughness Ra of the $Si_3N_4$ polycrystal after the polishing was 2.4 nm. The results are summarized in Table I.

Example 11

A polishing slurry was prepared by the same method as used in Example 3, except that 5 wt. % $ZrO_2$ abrasive grains having an average grain diameter of 2.5 $\mu$m as oxide abrasive grains and 0.4 wt. % $Ca(NO_3)_2$ as an inorganic dispersant were added without adding an anionic organic dispersant. Then, the evaluation of dispersibility of the oxide abrasive grains and the CMP of an $Si_3N_4$ polycrystal were performed. The polishing slurry of Example 11 had abrasive grains with an average grain diameter of 0.5 $\mu$m, a pH of 3.5, and an ORP of 1,250 mV The dispersibility of the oxide abrasive grains was 18%. The polishing rate for the $Si_3N_4$ polycrystal was 2.6 $\mu$m/hr. The surface roughness Ra of the

$Si_3N_4$ polycrystal after the polishing was as extremely low as 1.8 nm. The results are summarized in Table II.

Example 12

A polishing slurry was prepared by the same method as used in Example 11, except that 0.4 wt. % $Al(NO_3)_3$ was added as the inorganic dispersant. Then, the evaluation of dispersibility of the oxide abrasive grains and the CMP of an $Si_3N_4$ polycrystal were performed. The polishing slurry of Example 12 had abrasive grains with an average grain diameter of 0.5 $\mu$m, a pH of 3.5, and an ORP of 1,250 mV The dispersibility of the oxide abrasive grains was 18%. The polishing rate for the $Si_3N_4$ polycrystal was 2.8 $\mu$m/hr. The surface roughness Ra of the $Si_3N_4$ polycrystal after the polishing was as extremely low as 1.7 nm. The results are summarized in Table II.

Example 13

A polishing slurry was prepared by the same method as used in Example 11, except that 0.1 wt. % PAA, which is an anionic organic dispersant, having a number average molecular weight of 2,000 was further added. Then, the evaluation of dispersibility of the oxide abrasive grains and the CMP of an $Si_3N_4$ polycrystal were performed. The polishing slurry of Example 13 had abrasive grains with an average grain diameter of 0.5 $\mu$m, a pH of 4.2, and an ORP of 1,200 mV The dispersibility of the oxide abrasive grains was as high as 28%. The polishing rate for the $Si_3N_4$ polycrystal was 1.7 $\mu$m/hr. The surface roughness Ra of the $Si_3N_4$ polycrystal after the polishing was as extremely low as 0.9 nm. The results are summarized in Table II.

Example 14

A polishing slurry was prepared by the same method as used in Example 13, except that 0.1 wt. % PAA having a number average molecular weight of 6,000 as the anionic organic dispersant, 0.1 wt. % $NaNO_3$ in place of $Ca(NO_3)_2$ as the inorganic dispersant, and 0.1-g/L trichloroisocyanuric acid sodium (hereinafter referred to as TCIA as an oxidizing reagent were added. Then, the evaluation of dispersibility of the oxide abrasive grains and the CMP of an $Si_3N_4$ polycrystal were performed. The polishing slurry of Example 14 had abrasive grains with an average grain diameter of 0.5 $\mu$m, a pH of 1.8, and an ORP of 1,400 mV The dispersibility of the oxide abrasive grains was 30%. The polishing rate for the $Si_3N_4$ polycrystal was as high as 2.2 $\mu$m/hr. The surface roughness Ra of the $Si_3N_4$ polycrystal after the polishing was as extremely low as 0.7 nm. The results are summarized in Table II.

Example 15

A polishing slurry was prepared by the same method as used in Example 13, except that a 0.1 wt. % NSH having a number average molecular weight of 10,000 as the anionic organic dispersant, 0.4 wt. % $Mg(NO_3)_2$ as the inorganic dispersant, and 0.4-g/L DCIA as the oxidizing reagent were added. Then, the evaluation of dispersibility of the oxide abrasive grains and the CMP of an $Si_3N_4$ polycrystal were performed. The polishing slurry of Example 15 had abrasive grains with an average grain diameter of 0.5 $\mu$m, a pH of 3.8, and an ORP of 1,250 mV The dispersibility of the oxide abrasive grains was 41%. The polishing rate for the $Si_3N_4$ polycrystal was as high as 1.8 $\mu$m/hr. The surface roughness Ra of the $Si_3N_4$ polycrystal after the polishing was as extremely low as 0.8 nm. The results are summarized in Table II.

Example 16

A polishing slurry was prepared by the same method as used in Example 15, except that 0.4 wt. % $Fe(NO_3)_2$ was added as the inorganic dispersant. Then, the evaluation of dispersibility of the oxide abrasive grains and the CMP of an $Si_3N_4$ polycrystal were performed. The polishing slurry of Example 16 had abrasive grains with an average grain diameter of 0.5 $\mu$m, a pH of 3.8, and an ORP of 1,250 mV The dispersibility of the oxide abrasive grains was 39%. The polishing rate for the $Si_3N_4$ polycrystal was as high as 1.9 $\mu$m/hr. The surface roughness Ra of the $Si_3N_4$ polycrystal after the polishing was as extremely low as 0.7 nm. The results are summarized in Table II.

Example 17

A polishing slurry was prepared by the same method as used in Example 16, except that 0.4 wt. % $Al_2(NO_3)_3$ was added as the inorganic dispersant. Then, the evaluation of dispersibility of the oxide abrasive grains and the CMP of an $Si_3N_4$ polycrystal were performed. The polishing slurry of Example 17 had abrasive grains with an average grain diameter of 0.5 $\mu$m, a pH of 3.8, and an ORP of 1,250 mV The dispersibility of the oxide abrasive grains was 49%. The polishing rate for the $Si_3N_4$ polycrystal was as high as 2.0 $\mu$m/hr. The surface roughness Ra of the $Si_3N_4$ polycrystal after the polishing was as extremely low as 0.7 nm. The results are summarized in Table II.

Example 18

A polishing slurry was prepared by the same method as used in Example 16, except that 0.4 wt. % $Ni(NO_3)_2$ was added as the inorganic dispersant. Then, the evaluation of dispersibility of the oxide abrasive grains and the CMP of an $Si_3N_4$ polycrystal were performed. The polishing slurry of Example 18 had abrasive grains with an average grain diameter of 0.5 $\mu$m, a pH of 3.7, and an ORP of 1,250 mV The dispersibility of the oxide abrasive grains was 43%. The polishing rate for the $Si_3N_4$ polycrystal was as high as 1.8 $\mu$m/hr. The surface roughness Ra of the $Si_3N_4$ polycrystal after the polishing was as extremely low as 0.7 nm. The results are summarized in Table II.

Example 19

A polishing slurry was prepared by the same method as used in Example 16, except that 0.4 wt. % $Cr(NO_3)_3$ was added as the inorganic dispersant. Then, the evaluation of dispersibility of the oxide abrasive grains and the CMP of an Si3N4 polycrystal were performed. The polishing slurry of Example 19 had abrasive grains with an average grain diameter of 0.5 $\mu$m, a pH of 3.6, and an ORP of 1,250 mV. The dispersibility of the oxide abrasive grains was 35%. The polishing rate for the $Si_3N_4$ polycrystal was as high as 1.7 $\mu$m/hr. The surface roughness Ra of the $Si_3N_4$ polycrystal after the polishing was as extremely low as 0.6 nm. The results are summarized in Table II.

Example 20

A polishing slurry was prepared by the same method as used in Example 16, except that 0.4 wt. % $Cu(NO_3)_2$ was added as the inorganic dispersant. Then, the evaluation of dispersibility of the oxide abrasive grains and the CMP of an $Si_3N_4$ polycrystal were performed. The polishing slurry of Example 20 had abrasive grains with an average grain diameter of 0.5 $\mu$m, a pH of 3.8, and an ORP of 1,250 mV. The dispersibility of the oxide abrasive grains was 36%. The polishing rate for the $Si_3N_4$ polycrystal was as high as 1.7 $\mu$m/hr. The surface roughness Ra of the $Si_3N_4$ polycrystal after the polishing was as extremely low as 0.6 nm. The results are summarized in Table II.

Example 21

A polishing slurry was prepared by the same method as used in Example 16, except that 0.4 wt. % $Zn(NO_3)_2$ was added as the inorganic dispersant. Then, the evaluation of dispersibility of the oxide abrasive grains and the CMP of an $Si_3N_4$ polycrystal were performed. The polishing slurry of Example 21 had abrasive grains with an average grain diameter of 0.5 $\mu$m, a pH of 3.8, and an ORP of 1,250 mV. The dispersibility of the oxide abrasive grains was 46%. The polishing rate for the $Si_3N_4$ polycrystal was as high as 1.9 $\mu$m/hr. The surface roughness Ra of the $Si_3N_4$ polycrystal after the polishing was as extremely low as 0.7 nm. The results are summarized in Table II.

Example 22

A polishing slurry was prepared by the same method as used in Example 16, except that 0.4 wt. % $Mn(NO_3)_2$ was added as the inorganic dispersant. Then, the evaluation of dispersibility of the oxide abrasive grains and the CMP of an $Si_3N_4$ polycrystal were performed. The polishing slurry of Example 22 had abrasive grains with an average grain diameter of 0.5 $\mu$m, a pH of 3.7, and an ORP of 1,250 mV. The dispersibility of the oxide abrasive grains was 39%. The polishing rate for the $Si_3N_4$ polycrystal was as high as 1.8 $\mu$m/hr. The surface roughness Ra of the $Si_3N_4$ polycrystal after the polishing was as extremely low as 0.7 nm. The results are summarized in Table II.

Example 23

A polishing slurry was prepared by the same method as used in Example 16, except that 0.4 wt. % $Na_2SO_4$ was added as the inorganic dispersant. Then, the evaluation of dispersibility of the oxide abrasive grains and the CMP of an $Si_3N_4$ polycrystal were performed. The polishing slurry of Example 23 had abrasive grains with an average grain diameter of 0.5 $\mu$m, a pH of 3.8, and an ORP of 1,250 mV The dispersibility of the oxide abrasive grains was 38%. The polishing rate for the $Si_3N_4$ polycrystal was as high as 1.7 $\mu$m/hr. The surface roughness Ra of the $Si_3N_4$ polycrystal after the polishing was as extremely low as 0.6 nm. The results are summarized in Table II.

Example 24

A polishing slurry was prepared by the same method as used in Example 16, except that a 0.1 wt. % NSH having a number average molecular weight of 5,000 as the anionic organic dispersant, 0.4 wt. % $MgSO_4$ as the inorganic dispersant, and 2.0-g/L $H_2O_2$ as the oxidizing reagent were added. Then, the evaluation of dispersibility of the oxide abrasive grains and the CMP of an $Si_3N_4$ polycrystal were performed. The polishing slurry of Example 24 had abrasive grains with an average grain diameter of 0.5 $\mu$m, a pH of 4.0, and an ORP of 750 mV The dispersibility of the oxide abrasive grains was 30%. The polishing rate for the $Si_3N_4$ polycrystal was as high as 0.9 $\mu$m/hr. The surface roughness Ra of the $Si_3N_4$ polycrystal after the polishing was as extremely low as 1.4 nm. The results are summarized in Table III.

Example 25

A polishing slurry was prepared by the same method as used in Example 16, except that 5 wt. % $Cr_2O_3$ abrasive grains having an average grain diameter of 2.5 $\mu$m as oxide abrasive grains, 0.4 wt. % $Al_2(SO_4)_3$ as the inorganic dispersant, and 0.1-g/L TCIA as the oxidizing reagent were added. Then, the evaluation of dispersibility of the oxide abrasive grains and the CMP of an $Si_3N_4$ polycrystal were performed. The polishing slurry of Example 25 had abrasive grains with an average grain diameter of 0.5 $\mu$m, a pH of 2.2, and an ORP of 1,400 mV The dispersibility of the oxide abrasive grains was 40%. The polishing rate for the $Si_3N_4$ polycrystal was as high as 3.0 $\mu$m/hr. The surface roughness Ra of the $Si_3N_4$ polycrystal after the polishing was as extremely low as 1.0 nm. The results are summarized in Table III.

Example 26

A polishing slurry was prepared by the same method as used in Example 25, except that 0.4 wt. % $NiSO_4$ was added as the inorganic dispersant. Then, the evaluation of dispersibility of the oxide abrasive grains and the CMP of an $Si_3N_4$ polycrystal were performed. The polishing slurry of Example 26 had abrasive grains with an average grain diameter of 0.5 $\mu$m, a pH of 2.2, and an ORP of 1,400 mV. The dispersibility of the oxide abrasive grains was 39%. The polishing rate for the $Si_3N_4$ polycrystal was as high as 2.9 $\mu$m/hr. The surface roughness Ra of the $Si_3N_4$ polycrystal after the polishing was as extremely low as 1.0 nm. The results are summarized in Table III.

Example 27

A polishing slurry was prepared by the same method as used in Example 25, except that 0.4 wt. % $Cr_2(SO_4)_3$ was added as the inorganic dispersant. Then, the evaluation of dispersibility of the oxide abrasive grains and the CMP of an $Si_3N_4$ polycrystal were performed. The polishing slurry of Example 27 had abrasive grains with an average grain diameter of 0.5 $\mu$m, a pH of 2.2, and an ORP of 1,400 mV The dispersibility of the oxide abrasive grains was 36%. The polishing rate for the $Si_3N_4$ polycrystal was as high as 2.8 $\mu$m/hr. The surface roughness Ra of the $Si_3N_4$ polycrystal after the polishing was as extremely low as 0.9 nm. The results are summarized in Table III.

Example 28

A polishing slurry was prepared by the same method as used in Example 25, except that 0.4 wt. % $CuSO_4$ was added as the inorganic dispersant. Then, the evaluation of dispersibility of the oxide abrasive grains and the CMP of an $Si_3N_4$ polycrystal were performed. The polishing slurry of Example 28 had abrasive grains with an average grain diameter of 0.5 $\mu$m, a pH of 2.2, and an ORP of 1,400 mV The dispersibility of the oxide abrasive grains was 41%. The polishing rate for the $Si_3N_4$ polycrystal was as high as 2.8 $\mu$m/hr. The surface roughness Ra of the $Si_3N_4$ polycrystal after the polishing was as extremely low as 0.9 nm. The results are summarized in Table III.

Example 29

A polishing slurry was prepared by the same method as used in Example 25, except that 0.4 wt. % $FeSO_4$ was added as the inorganic dispersant. Then, the evaluation of dispersibility of the oxide abrasive grains and the CMP of an $Si_3N_4$ polycrystal were performed. The polishing slurry of Example 29 had abrasive grains with an average grain diameter of 0.5 $\mu$m, a pH of 2.2, and an ORP of 1,400 mV The dispersibility of the oxide abrasive grains was 40%. The polishing rate for the $Si_3N_4$ polycrystal was as high as 2.7 $\mu$m/hr. The surface roughness Ra of the $Si_3N_4$ polycrystal after the polishing was as extremely low as 1.0 nm. The results are summarized in Table III.

Example 30

A polishing slurry was prepared by the same method as used in Example 25, except that 0.4 wt. % $ZnSO_4$ was added as the inorganic dispersant. Then, the evaluation of dispersibility of the oxide abrasive grains and the CMP of an $Si_3N_4$ polycrystal were performed. The polishing slurry of Example 30 had abrasive grains with an average grain diameter of 0.5 $\mu$m, a pH of 2.2, and an ORP of 1,400 mV. The dispersibility of the oxide abrasive grains was 40%. The polishing rate for the $Si_3N_4$ polycrystal was as high as 2.9 $\mu$m/hr. The surface roughness Ra of the $Si_3N_4$ polycrystal after the polishing was as extremely low as 1.0 nm. The results are summarized in Table III.

Example 31

A polishing slurry was prepared by the same method as used in Example 25, except that 0.4 wt. % $MnSO_4$ was added as the inorganic dispersant. Then, the evaluation of dispersibility of the oxide abrasive grains and the CMP of an $Si_3N_4$ polycrystal were performed. The polishing slurry of Example 31 had abrasive grains with an average grain diameter of 0.5 $\mu$m, a pH of 2.2, and an ORP of 1,400 mV The dispersibility of the oxide abrasive grains was 39%. The polishing rate for the $Si_3N_4$ polycrystal was as high as 2.8 $\mu$m/hr. The surface roughness Ra of the $Si_3N_4$ polycrystal after the polishing was as extremely low as 0.9 nm. The results are summarized in Table III.

Example 32

A polishing slurry was prepared by the same method as used in Example 24, except that 5 wt. % $Al_2O_3$ abrasive grains having an average grain diameter of 2.5 $\mu$m as oxide abrasive grains, 0.1 wt. % HDTP having a number average molecular weight of 805 as the anionic organic dispersant, and 0.4 wt. % Na-$HCO_3$ as the inorganic dispersant were added. Then, the evaluation of dispersibility of the oxide abrasive grains and the CMP of an $Si_3N_4$ polycrystal were performed. The polishing slurry of Example 32 had abrasive grains with an average grain diameter of 0.5 $\mu$m, a pH of 4.5, and an ORP of 700 mV The dispersibility of the oxide abrasive grains was 13%. The polishing rate for the $Si_3N_4$ polycrystal was 0.6 $\mu$m/hr. The surface roughness Ra of the $Si_3N_4$ polycrystal after the polishing was as extremely low as 0.6 nm. The results are summarized in Table III.

Example 33

A polishing slurry was prepared by the same method as used in Example 32, except that 0.4 wt. % $Na_2CO_3$ was added as the inorganic dispersant. Then, the evaluation of dispersibility of the oxide abrasive grains and the CMP of an $Si_3N_4$ polycrystal were performed. The polishing slurry of Example 33 had abrasive grains with an average grain diameter of 0.5 $\mu$m, a pH of 4.5, and an ORP of 700 mV The dispersibility of the oxide abrasive grains was 14%. The polishing rate for the $Si_3N_4$ polycrystal was 0.6 $\mu$m/hr. The surface roughness Ra of the $Si_3N_4$ polycrystal after the polishing was as extremely low as 0.6 nm. The results are summarized in Table III.

Example 34

A polishing slurry was prepared by the same method as used in Example 14, except that 0.1 wt. % HDTP having a number average molecular weight of 805 as the anionic organic dispersant and 0.4 wt. % $Na_3PO_4$ as the inorganic dispersant were added. Then, the evaluation of dispersibility of the oxide abrasive grains and the CMP of an $Si_3N_4$ polycrystal were performed. The polishing slurry of Example 34 had abrasive grains with an average grain diameter of 0.5 $\mu$m, a pH of 2.5, and an ORP of 1,350 mV The dispersibility of the oxide abrasive grains was 14%. The polishing rate for the $Si_3N_4$ polycrystal was 0.9 $\mu$m/hr. The surface roughness Ra of the $Si_3N_4$ polycrystal after the polishing was as extremely low as 0.8 nm. The results are summarized in Table IV.

Example 35

A polishing slurry was prepared by the same method as used in Example 34, except that 0.4 wt. % $CaCl_2$ was added as the inorganic dispersant. Then, the evaluation of dispersibility of the oxide abrasive grains and the CMP of an $Si_3N_4$ polycrystal were performed. The polishing slurry of Example 35 had abrasive grains with an average grain diameter of 0.5 $\mu$m, a pH of 2.5, and an ORP of 1,350 mV. The dispersibility of the oxide abrasive grains was 13%. The polishing rate for the $Si_3N_4$ polycrystal was 0.9 $\mu$m/hr. The surface roughness Ra of the $Si_3N_4$ polycrystal after the polishing was as extremely low as 0.8 nm. The results are summarized in Table IV.

Example 36

A polishing slurry was prepared by the same method as used in Example 34, except that 0.4 wt. % NaCl was added as the inorganic dispersant. Then, the evaluation of dispersibility of the oxide abrasive grains and the CMP of an $Si_3N_4$ polycrystal were performed. The polishing slurry of Example 36 had abrasive grains with an average grain diameter of 0.5 $\mu$m, a pH of 2.5, and an ORP of 1,350 mV The dispersibility of the oxide abrasive grains was 14%. The polishing rate for the $Si_3N_4$ polycrystal was 0.8 $\mu$m/hr. The surface roughness Ra of the $Si_3N_4$ polycrystal after the polishing was as extremely low as 0.8 nm. The results are summarized in Table IV.

Example 37

A polishing slurry was prepared by the same method as used in Example 34, except that 0.4 wt. % $AlCl_3$ was added as the inorganic dispersant. Then, the evaluation of dispersibility of the oxide abrasive grains and the CMP of an $Si_3N_4$ polycrystal were performed. The polishing slurry of Example 37 had abrasive grains with an average grain diameter of 0.5 $\mu$m, a pH of 2.5, and an ORP of 1,350 mV. The dispersibility of the oxide abrasive grains was 14%. The polishing rate for the $Si_3N_4$ polycrystal was 0.9 $\mu$m/hr. The surface roughness Ra of the $Si_3N_4$ polycrystal after the polishing was as extremely low as 0.8 nm. The results are summarized in Table IV.

Example 38

A polishing slurry was prepared by the same method as used in Example 34, except that 0.4 wt. % $MgCl_2$ was added as the inorganic dispersant. Then, the evaluation of dispersibility of the oxide abrasive grains and the CMP of an $Si_3N_4$ polycrystal were performed. The polishing slurry of Example 38 had abrasive grains with an average grain diameter of 0.5 $\mu$m, a pH of 2.5, and an ORP of 1,350 mV The dispersibility of the oxide abrasive grains was 14%. The polishing rate for the $Si_3N_4$ polycrystal was 0.8 $\mu$m/hr. The surface roughness Ra of the $Si_3N_4$ polycrystal after the polishing was as extremely low as 0.9 nm. The results are summarized in Table IV.

Example 39

A polishing slurry was prepared by the same method as used in Example 34, except that 0.4 wt. % $NiCl_2$ was added as the inorganic dispersant. Then, the evaluation of dispersibility of the oxide abrasive grains and the CMP of an $Si_3N_4$ polycrystal were performed. The polishing slurry of Example 39 had abrasive grains with an average grain diameter of 0.5 $\mu$m, a pH of 2.5, and an ORP of 1,350 mV The dispersibility of the oxide abrasive grains was 15%. The polishing rate for the $Si_3N_4$ polycrystal was 0.8 $\mu$m/hr. The surface roughness Ra of the $Si_3N_4$ polycrystal after the polishing was as extremely low as 0.8 nm. The results are summarized in Table IV.

Example 40

A polishing slurry was prepared by the same method as used in Example 34, except that 0.4 wt. % $CuCl_2$ was added as the inorganic dispersant. Then, the evaluation of dispersibility of the oxide abrasive grains and the CMP of an $Si_3N_4$ polycrystal were performed. The polishing slurry of Example 40 had abrasive grains with an average grain diameter of 0.5 $\mu$m, a pH of 2.5, and an ORP of 1,350 mV The dispersibility of the oxide abrasive grains was 14%. The polishing rate for the $Si_3N_4$ polycrystal was 0.9 $\mu$m/hr. The surface roughness Ra of the $Si_3N_4$ polycrystal after the polishing was as extremely low as 0.8 nm. The results are summarized in Table IV.

Example 41

A polishing slurry was prepared by the same method as used in Example 34, except that 0.4 wt. % $FeCl_2$ was added as the inorganic dispersant. Then, the evaluation of dispersibility of the oxide abrasive grains and the CMP of an $Si_3N_4$ polycrystal were performed. The polishing slurry of Example 41 had abrasive grains with an average grain diameter of 0.5 $\mu$m, a pH of 2.5, and an ORP of 1,350 mV The dispersibility of the oxide abrasive grains was 14%. The polishing rate for the $Si_3N_4$ polycrystal was 0.8 $\mu$m/hr. The surface roughness Ra of the $Si_3N_4$ polycrystal after the polishing was as extremely low as 0.8 nm. The results are summarized in Table IV.

Example 42

A polishing slurry was prepared by the same method as used in Example 34, except that 0.4 wt. % $ZnCl_2$ was added as the inorganic dispersant. Then, the evaluation of dispersibility of the oxide abrasive grains and the CMP of an

$Si_3N_4$ polycrystal were performed. The polishing slurry of Example 42 had abrasive grains with an average grain diameter of 0.5 $\mu$m, a pH of 2.5, and an ORP of 1,350 mV The dispersibility of the oxide abrasive grains was 13%. The polishing rate for the $Si_3N_4$ polycrystal was 0.9 $\mu$m/hr. The surface roughness Ra of the $Si_3N_4$ polycrystal after the polishing was as extremely low as 0.9 nm. The results are summarized in Table IV.

Example 43

A polishing slurry was prepared by the same method as used in Example 34, except that 0.4 wt. % $MnCl_2$ was added as the inorganic dispersant. Then, the evaluation of dispersibility of the oxide abrasive grains and the CMP of an $Si_3N_4$ polycrystal were performed. The polishing slurry of Example 43 had abrasive grains with an average grain diameter of 0.5 $\mu$m, a pH of 2.5, and an ORP of 1,350 mV The dispersibility of the oxide abrasive grains was 14%. The polishing rate for the $Si_3N_4$ polycrystal was 0.9 $\mu$m/hr. The surface roughness Ra of the $Si_3N_4$ polycrystal after the polishing was as extremely low as 0.8 nm. The results are summarized in Table IV.

Comparative example 3

A polishing slurry was prepared by the same method as used in Example 43, except that 0.1 wt. % HDTMAC, which is a cationic organic dispersant, having a number average molecular weight of 320 was added in place of HDTP, which is an anionic organic dispersant, that no inorganic dispersant was added, and that 0.4-g/L DCIA was added as the oxidizing reagent. Then, the evaluation of dispersibility of the oxide abrasive grains and the CMP of an $Si_3N_4$ polycrystal were performed. The polishing slurry of Comparative example 3 had abrasive grains with an average grain diameter of 0.5 $\mu$m, a pH of 2.5, and an ORP of 1,350 mV. The dispersibility of the oxide abrasive grains was as low as 6%. The polishing rate for the $Si_3N_4$ polycrystal was 0.1 $\mu$m/hr. The surface roughness Ra of the $Si_3N_4$ polycrystal after the polishing was 2.4 nm. The results are summarized in Table IV.

Comparative example 4

A polishing slurry was prepared by the same method as used in Example 25, except that 0.1 wt. % POE(10), which is a nonionic organic dispersant, having a number average molecular weight of 645 was added in place of the NSH, which is an anionic organic dispersant and that no inorganic dispersant was added. Then, the evaluation of dispersibility of the oxide abrasive grains and the CMP of an $Si_3N_4$ polycrystal were performed. The polishing slurry of Comparative example 4 had abrasive grains with an average grain diameter of 1 $\mu$m, a pH of 2.5, and an ORP of 1,350 mV The dispersibility of the oxide abrasive grains was as low as 8%. The polishing rate for the $Si_3N_4$ polycrystal was 0.2 $\mu$m/hr. The surface roughness Ra of the $Si_3N_4$ polycrystal after the polishing was 2.3 nm. The results are summarized in Table IV.

Example 44

A polishing slurry was prepared by adding 10 wt. % $Al_2O_3$ abrasive grains as oxide abrasive grains, 0.1 wt. % PAA having a number average molecular weight of 2,000 as an anionic organic dispersant, 0.4 wt. % $NaNO_3$ as an inorganic dispersant, and 0.1-g/L TCIA as an oxidizing reagent. Then, the evaluation of dispersibility of the oxide abrasive grains and the CMP of an $Si_3N_4$ polycrystal were performed. The polishing slurry of Example 44 had abrasive grains with an average grain diameter of 0.5 $\mu$m, a pH of 1.8, and an ORP of 1,400 mV The dispersibility of the oxide abrasive grains was 40%. The polishing rate for the $Si_3N_4$ polycrystal was 3.4 $\mu$m/hr. The surface roughness Ra of the $Si_3N_4$ polycrystal after the polishing was as extremely low as 1.1 nm. The results are summarized in Table V.

Example 45

A polishing slurry was prepared by the same method as used in Example 44, except that 10 wt. % $Cr_2O_3$ abrasive grains as the oxide abrasive grains and 0.1 wt. % PAA having a number average molecular weight of 6,000 as the anionic organic dispersant were added. Then, the evaluation of dispersibility of the oxide abrasive grains and the CMP of an $Si_3N_4$ polycrystal were performed. The polishing slurry of Example 45 had abrasive grains with an average grain diameter of 1 $\mu$m, a pH of 2.5, and an ORP of 1,350 mV The dispersibility of the metallic oxide abrasive grains was as high as 55%. The polishing rate for the $Si_3N_4$ polycrystal was 3.3 $\mu$m/hr. The surface roughness Ra of the $Si_3N_4$ polycrystal after the polishing was as extremely low as 1.0 nm. The results are summarized in Table V.

Example 46

A polishing slurry was prepared by the same method as used in Example 45, except that the addition of 10 wt. % $Fe_2O_3$ abrasive grains as the oxide abrasive grains was performed. Then, the evaluation of dispersibility of the oxide abrasive grains and the CMP of an $Si_3N_4$ polycrystal were performed. The polishing slurry of Example 46 had abrasive grains with an average grain diameter of 0.5 $\mu$m, a pH of 2.5, and an ORP of 1,350 mV The dispersibility of the metallic oxide abrasive grains was as high as 61%. The polishing rate for the $Si_3N_4$ polycrystal was 0.8 $\mu$m/hr. The surface roughness Ra of the $Si_3N_4$ polycrystal after the polishing was as extremely low as 0.3 nm. The results are summarized in Table V.

Example 47

A polishing slurry was prepared by the same method as used in Example 46, except that 5 wt. % $ZrO_2$ abrasive grains as the oxide abrasive grains and a 0.1 wt. % NSH having a number average molecular weight of 5,000 as the anionic organic dispersant were added. Then, the evaluation of dispersibility of the oxide abrasive grains and the CMP of an $Si_3N_4$ polycrystal were performed. The polishing slurry of Example 47 had abrasive grains with an average grain diameter of 0.3 $\mu$m, a pH of 2.5, and an ORP of 1,350 mV The dispersibility of the metallic oxide abrasive grains was 27%. The polishing rate for the $Si_3N_4$ polycrystal was 1.5 $\mu$m/hr. The surface roughness Ra of the $Si_3N_4$ polycrystal after the polishing was as extremely low as 0.6 nm. The results are summarized in Table V.

Example 48

A polishing slurry was prepared by the same method as used in Example 47, except that 10 wt. % $TiO_2$ abrasive grains as the oxide abrasive grains and a 0.1 wt. % NSH having a number average molecular weight of 10,000 as the anionic organic dispersant were added. Then, the evaluation of dispersibility of the oxide abrasive grains and the CMP of an $Si_3N_4$ polycrystal were performed. The polishing slurry of Example 48 had abrasive grains with an average grain diameter of 0.1 $\mu$m, a pH of 2.5, and an ORP of 1,350 mV The dispersibility of the oxide abrasive grains was as high as 88%. The polishing rate for the $Si_3N_4$ polycrystal was 0.6 $\mu$m/hr. The surface roughness Ra of the $Si_3N_4$ polycrystal after the polishing was as extremely low as 0.4 nm. The results are summarized in Table V.

Example 49

A polishing slurry was prepared by the same method as used in Example 48, except that 5 wt. % NiO abrasive grains as the oxide abrasive grains and 0.1 wt. % HDTP having a number average molecular weight of 805 as the anionic organic dispersant were added. Then, the evaluation of dispersibility of the oxide abrasive grains and the CMP of an $Si_3N_4$ polycrystal were performed. The polishing slurry of Example 49 had abrasive grains with an average grain diameter of 0.5 $\mu$m, a pH of 2.5, and an ORP of 1,350 mV. The dispersibility of the metallic oxide abrasive grains was 12%. The polishing rate for the $Si_3N_4$ polycrystal was 1.3 $\mu$m/hr. The surface roughness Ra of the $Si_3N_4$ polycrystal after the polishing was as extremely low as 0.5 nm. The results are summarized in Table V.

Example 50

A polishing slurry was prepared by the same method as used in Example 49, except that the addition of 10 wt. % $SiO_2$ abrasive grains as the oxide abrasive grains was performed. Then, the evaluation of dispersibility of the oxide abrasive grains and the CMP of an $Si_3N_4$ polycrystal were performed. The polishing slurry of Example 50 had abrasive grains with an average grain diameter of 0.2 $\mu$m, a pH of 2.5, and an ORP of 1,350 mV The dispersibility of the oxide abrasive grains was 29%. The polishing rate for the $Si_3N_4$ polycrystal was 0.4 $\mu$m/hr. The surface roughness Ra of the $Si_3N_4$ polycrystal after the polishing was as extremely low as 0.4 nm. The results are summarized in Table V.

Example 51

A polishing slurry was prepared by the same method as used in Example 44, except that 0.1 wt. % PAA having a number average molecular weight of 35,000 was added as the anionic organic dispersant. Then, the evaluation of dispersibility of the oxide abrasive grains and the CMP of an $Si_3N_4$ polycrystal were performed. The polishing slurry of Example 51 had abrasive grains with an average grain diameter of 2 $\mu$m, a pH of 3.0, and an ORP of 1,000 mV The dispersibility of the oxide abrasive grains was 91%. The polishing rate for the $Si_3N_4$ polycrystal was 2.8 $\mu$m/hr. The surface roughness Ra of the $Si_3N_4$ polycrystal after the polishing was as extremely low as 1.6 nm. The results are summarized in Table V.

Example 52

A polishing slurry was prepared by the same method as used in Example 51, except that the addition of 5 wt. % $Cr_2O_3$ abrasive grains as the oxide abrasive grains was performed. Then, the evaluation of dispersibility of the oxide abrasive grains and the CMP of an $Si_3N_4$ polycrystal were performed. The polishing slurry of Example 52 had abrasive grains with an average grain diameter of 2 $\mu$ m, a pH of 3.0, and an ORP of 1,000 mV. The dispersibility of the oxide abrasive grains was 46%. The polishing rate for the $Si_3N_4$ polycrystal was 2.7 $\mu$ m/hr. The surface roughness Ra of the $Si_3N_4$ polycrystal after the polishing was as extremely low as 1.5 nm. The results are summarized in Table V.

Example 53

A polishing slurry was prepared by the same method as used in Example 51, except that the addition of 10 wt. % $Fe_3O_4$ abrasive grains as the oxide abrasive grains was performed. Then, the evaluation of dispersibility of the oxide abrasive grains and the CMP of an $Si_3N_4$ polycrystal were performed. The polishing slurry of Example 53 had abrasive grains with an average grain diameter of 0.5 $\mu$ m, a pH of 3.0, and an ORP of 1,000 mV. The dispersibility of the oxide abrasive grains was 90%. The polishing rate for the $Si_3N_4$ polycrystal was 0.8 $\mu$ m/hr. The surface roughness Ra of the $Si_3N_4$ polycrystal after the polishing was as extremely low as 0.4 nm. The results are summarized in Table V.

Example 54

A polishing slurry was prepared by the same method as used in Example 51, except that the addition of 5 wt. % CuO abrasive grains as the oxide abrasive grains was performed. Then, the evaluation of dispersibility of the oxide abrasive grains and the CMP of an $Si_3N_4$ polycrystal were performed. The polishing slurry of Example 54 had abrasive grains with an average grain diameter of 0.5 $\mu$ m, a pH of 3.0, and an ORP of 1,000 mV The dispersibility of the oxide abrasive grains was 48%. The polishing rate for the $Si_3N_4$ polycrystal was 0.5 $\mu$ m/hr. The surface roughness Ra of the $Si_3N_4$ polycrystal after the polishing was as extremely low as 0.3 nm. The results are summarized in Table V.

Example 55

A polishing slurry was prepared by the same method as used in Example 51, except that the addition of 5 wt. % $MnO_2$ abrasive grains as the oxide abrasive grains was performed. Then, the evaluation of dispersibility of the oxide abrasive grains and the CMP of an $Si_3N_4$ polycrystal were performed. The polishing slurry of Example 55 had abrasive grains with an average grain diameter of 0.5 $\mu$ m, a pH of 3.0, and an ORP of 1,000 mV The dispersibility of the oxide abrasive grains was 52%. The polishing rate for the $Si_3N_4$ polycrystal was 0.9 $\mu$ m/hr. The surface roughness Ra of the $Si_3N_4$ polycrystal after the polishing was as extremely low as 0.4 nm. The results are summarized in Table V.

Comparative example 5

A polishing slurry was prepared by the same method as used in Example 48, except that the addition of 5 wt. % $Al_2O_3$ abrasive grains as the oxide abrasive grains was performed and that no oxidizing reagent was added. Then, the evaluation of dispersibility of the oxide abrasive grains and the CMP of an $Si_3N_4$ polycrystal were performed. The polishing slurry of Comparative example 5 had abrasive grains with an average grain diameter of 0.5 $\mu$ m, a pH of 4.5, and an ORP of 700 mV. The dispersibility of the oxide abrasive grains was 50%. The polishing rate for the $Si_3N_4$ polycrystal was 0.2 $\mu$ m/hr. The surface roughness Ra of the $Si_3N_4$ polycrystal after the polishing was 2.1 nm. The results are summarized in Table V.

Comparative example 6

A polishing slurry was prepared by the same method as used in Example 49, except that the addition of 5 wt. % $ZrO_2$ abrasive grains as the oxide abrasive grains was performed and that no oxidizing reagent was added. Then, the evaluation of dispersibility of the oxide abrasive grains and the CMP of an $Si_3N_4$ polycrystal were performed. The polishing slurry of Comparative example 6 had abrasive grains with an average grain diameter of 0.5 $\mu$ m, a pH of 4.5, and an ORP of 700 mV The dispersibility of the oxide abrasive grains was 14%. The polishing rate for the $Si_3N_4$ polycrystal was 0.1 $\mu$ m/hr. The surface roughness Ra of the $Si_3N_4$ polycrystal after the polishing was 1.9 nm. The results are summarized in Table V.

Example 56

A polishing slurry was prepared by the same method as used in Example 3, except that 0.1 wt. % boehmite was added as an abrasive-grain-sinking retarder. Then, the evaluation of dispersibility of the oxide abrasive grains and the CMP of an $Si_3N_4$ polycrystal were performed. The polishing slurry had abrasive grains with an average grain diameter of 1 $\mu$ m, a pH of 4, and an ORP of 1,250 mV The dispersibility of the oxide abrasive grains was 31%. The polishing rate for the $Si_3N_4$ polycrystal was as high as 3.2 $\mu$ m/hr. The surface roughness Ra of the $Si_3N_4$ polycrystal after the polishing was as extremely low as 1.1 nm. The results are summarized in Table VI.

Example 57

A polishing slurry was prepared by the same method as used in Example 3, except that 1 wt. % boehmite was added as an abrasive-grain-sinking retarder. Then, the evaluation of dispersibility of the oxide abrasive grains and the CMP of an $Si_3N_4$ polycrystal were performed. The polishing slurry had abrasive grains with an average grain diameter of 1 $\mu$ m, a pH of 4, and an ORP of 1,250 mV. The dispersibility of the oxide abrasive grains was 49%. The polishing rate for the $Si_3N_4$ polycrystal was as high as 3.7 $\mu$ m/hr. The surface roughness Ra of the $Si_3N_4$ polycrystal after the polishing was as extremely low as 0.9 nm. The results are summarized in Table VI.

Example 58

A polishing slurry was prepared by the same method as used in Example 3, except that 2 wt. % boehmite was added as an abrasive-grain-sinking retarder. Then, the evaluation of dispersibility of the oxide abrasive grains and the CMP of an $Si_3N_4$ polycrystal were performed. The polishing slurry had abrasive grains with an average grain diameter of 1 $\mu$ m, a pH of 4, and an ORP of 1,250 mV The dispersibility of the oxide abrasive grains was 62%. The polishing rate for the $Si_3N_4$ polycrystal was as high as 4.1 $\mu$ m/hr. The surface roughness Ra of the $Si_3N_4$ polycrystal after the polishing was as extremely low as 0.8 nm. The results are summarized in Table VI.

Example 59

A polishing slurry was prepared by the same method as used in Example 3, except that 3 wt. % boehmite was added as an abrasive-grain-sinking retarder. Then, the evaluation of dispersibility of the oxide abrasive grains and the CMP of an $Si_3N_4$ polycrystal were performed. The polishing slurry had abrasive grains with an average grain diameter of 1 $\mu$ m, a pH of 4, and an ORP of 1,250 mV. The dispersibility of the oxide abrasive grains was 75%. The polishing rate for the $Si_3N_4$ polycrystal was as high as 4.5 $\mu$ m/hr. The surface roughness Ra of the $Si_3N_4$ polycrystal after the polishing was as extremely low as 0.7 nm. The results are summarized in Table VI.

Example 60

A polishing slurry was prepared by the same method as used in Example 3, except that 7 wt. % boehmite was added as an abrasive-grain-sinking retarder. Then, the evaluation of dispersibility of the oxide abrasive grains and the CMP of an $Si_3N_4$ polycrystal were performed. The polishing slurry had abrasive grains with an average grain diameter of 1 $\mu$ m, a pH of 4, and an ORP of 1,250 mV. The dispersibility of the oxide abrasive grains was 96%. The polishing rate for the $Si_3N_4$ polycrystal was as high as 3.4 $\mu$ m/hr. The surface roughness Ra of the $Si_3N_4$ polycrystal after the polishing was as extremely low as 1.1 nm. The results are summarized in Table VI.

Example 61

A polishing slurry was prepared by the same method as used in Example 58, except that 2 wt. % $Al(NO_3)_3$ was added as the inorganic dispersant. Then, the evaluation of dispersibility of the oxide abrasive grains and the CMP of an $Si_3N_4$ polycrystal were performed. The polishing slurry had abrasive grains with an average grain diameter of 1 $\mu$ m, a pH of 4, and an ORP of 1,250 mV The dispersibility of the oxide abrasive grains was 84%. The polishing rate for the $Si_3N_4$ polycrystal was as high as 3.9 $\mu$ m/hr. The surface roughness Ra of the $Si_3N_4$ polycrystal after the polishing was as extremely low as 0.6 nm. The results are summarized in Table VI.

Comparative example 7

A polishing slurry was prepared by the same method as used in Example 3, except that 8 wt. % boehmite was added as an abrasive-grain-sinking retarder. Then, the evaluation of dispersibility of the oxide abrasive grains was performed. The polishing slurry had abrasive grains with an average grain diameter of 1 $\mu$ m, a pH of 4, and an ORP of 1,250 mV The dispersibility of the oxide abrasive grains was as high as 98%. However, the polishing liquid was gelatinized, so that it was impossible to perform the CMP of an $Si_3N_4$ polycrystal. The results are summarized in Table VI.

Example 62

A polishing slurry was prepared by the same method as used in Example 14, except that 0.1 wt. % boehmite was added as an abrasive-grain-sinking retarder. Then, the evaluation of dispersibility of the oxide abrasive grains and the CMP of an $Si_3N_4$ polycrystal were performed. The polishing slurry had abrasive grains with an average grain diameter of 0.5 $\mu$ m, a pH of 1.8, and an ORP of 1,400 mV The dispersibility of the oxide abrasive grains was 39%. The polishing rate for the $Si_3N_4$ polycrystal was as high as 2.3 $\mu$ m/hr. The surface roughness Ra of the $Si_3N_4$ polycrystal after the polishing was as extremely low as 0.6 nm. The results are summarized in Table VII.

Example 63

A polishing slurry was prepared by the same method as used in Example 14, except that 1 wt. % boehmite was added as an abrasive-grain-sinking retarder. Then, the evaluation of dispersibility of the oxide abrasive grains and the CMP of an $Si_3N_4$ polycrystal were performed. The polishing slurry had abrasive grains with an average grain diameter of 0.5 $\mu$ m, a pH of 1.8, and an ORP of 1,400 mV. The dispersibility of the oxide abrasive grains was 53%. The polishing rate for the $Si_3N_4$ polycrystal was as high as 2.6 $\mu$ m/hr. The surface roughness Ra of the $Si_3N_4$ polycrystal after the polishing was as extremely low as 0.5 nm. The results are summarized in Table VII.

Example 64

A polishing slurry was prepared by the same method as used in Example 14, except that 2 wt. % boehmite was added as an abrasive-grain-sinking retarder. Then, the evaluation of dispersibility of the oxide abrasive grains and the CMP of an $Si_3N_4$ polycrystal were performed. The polishing slurry had abrasive grains with an average grain diameter of 0.5 $\mu$ m, a pH of 1.8, and an ORP of 1,400 mV. The dispersibility of the oxide abrasive grains was 69%. The polishing rate for the $Si_3N_4$ polycrystal was as high as 2.9 $\mu$ m/hr. The surface roughness Ra of the $Si_3N_4$ polycrystal after the polishing was as extremely low as 0.5 nm. The results are summarized in Table VII.

Example 65

A polishing slurry was prepared by the same method as used in Example 14, except that 3 wt. % boehmite was added as an abrasive-grain-sinking retarder. Then, the evaluation of dispersibility of the oxide abrasive grains and the CMP of an $Si_3N_4$ polycrystal were performed. The polishing slurry had abrasive grains with an average grain diameter of 0.5 $\mu$ m, a pH of 1.8, and an ORP of 1,400 mV The dispersibility of the oxide abrasive grains was 83%. The polishing rate for the $Si_3N_4$ polycrystal was as high as 3.2 $\mu$ m/hr. The surface roughness Ra of the $Si_3N_4$ polycrystal after the polishing was as extremely low as 0.4 nm. The results are summarized in Table VII.

Example 66

A polishing slurry was prepared by the same method as used in Example 14, except that 7 wt. % boehmite was added as an abrasive-grain-sinking retarder. Then, the evaluation of dispersibility of the oxide abrasive grains and the CMP of an $Si_3N_4$ polycrystal were performed. The polishing slurry had abrasive grains with an average grain diameter of 0.5 $\mu$ m, a pH of 1.8, and an ORP of 1,400 mV. The dispersibility of the oxide abrasive grains was 97%. The polishing rate for the $Si_3N_4$ polycrystal was as high as 2.5 $\mu$ m/hr. The surface roughness Ra of the $Si_3N_4$ polycrystal after the polishing was as extremely low as 0.6 nm. The results are summarized in Table VII.

Example 67

A polishing slurry was prepared by the same method as used in Example 64, except that 2 wt. % $NaNO_3$ was added as the inorganic dispersant. Then, the evaluation of dispersibility of the oxide abrasive grains and the CMP of an $Si_3N_4$ polycrystal were performed. The polishing slurry had abrasive grains with an average grain diameter of 0.5 $\mu$ m, a pH of 1.8, and an ORP of 1,400 mV The dispersibility of the oxide abrasive grains was 90%. The polishing rate for the $Si_3N_4$ polycrystal was as high as 2.8 $\mu$ m/hr. The surface roughness Ra of the $Si_3N_4$ polycrystal after the polishing was as extremely low as 0.3 nm. The results are summarized in Table VII.

Comparative example 8

A polishing slurry was prepared by the same method as used in Example 14, except that 8 wt. % boehmite was added as an abrasive-grain-sinking retarder. Then, the evaluation of dispersibility of the oxide abrasive grains was performed. The polishing slurry had abrasive grains with an average grain diameter of 0.5 $\mu$ m, a pH of 1.8, and an ORP of 1,400 mV The dispersibility of the oxide abrasive grains was as high as 99%. However, the polishing liquid was gelatinized, so that it was impossible to perform the CMP of an $Si_3N_4$ polycrystal. The results are summarized in Table VII.

Example 68

A polishing slurry was prepared by the same method as used in Example 25, except that 0.1 wt. % boehmite was added as an abrasive-grain-sinking retarder. Then, the evaluation of dispersibility of the oxide abrasive grains and the CMP of an $Si_3N_4$ polycrystal were performed. The polishing slurry had abrasive grains with an average grain diameter of 0.5 $\mu$ m, a pH of 2.2, and an ORP of 1,400 mV The dispersibility of the oxide abrasive grains was 47%. The polishing rate for the $Si_3N_4$ polycrystal was as high as 3.1 $\mu$ m/hr. The surface roughness Ra of the $Si_3N_4$ polycrystal after the polishing was as extremely low as 0.9 nm. The results are summarized in Table VIII.

Example 69

A polishing slurry was prepared by the same method as used in Example 25, except that 1 wt. % boehmite was added as an abrasive-grain-sinking retarder. Then, the evaluation of dispersibility of the oxide abrasive grains and the CMP of an $Si_3N_4$ polycrystal were performed. The polishing slurry had abrasive grains with an average grain diameter of 0.5 $\mu$ m, a pH of 2.2, and an ORP of 1,400 mV The dispersibility of the oxide abrasive grains was 65%. The polishing rate for the $Si_3N_4$ polycrystal was as high as 3.7 $\mu$ m/hr. The surface roughness Ra of the $Si_3N_4$ polycrystal after the polishing was as extremely low as 0.8 nm. The results are summarized in Table VIII.

Example 70

A polishing slurry was prepared by the same method as used in Example 25, except that 2 wt. % boehmite was added as an abrasive-grain-sinking retarder. Then, the evaluation of dispersibility of the oxide abrasive grains and the CMP of an $Si_3N_4$ polycrystal were performed. The polishing slurry had abrasive grains with an average grain diameter of 0.5 $\mu$ m, a pH of 2.2, and an ORP of 1,400 mV. The dispersibility of the oxide abrasive grains was 81%. The polishing rate for the $Si_3N_4$ polycrystal was as high as 4.1 $\mu$ m/hr. The surface roughness Ra of the $Si_3N_4$ polycrystal after the polishing was as extremely low as 0.7 nm. The results are summarized in Table VIII.

Example 71

A polishing slurry was prepared by the same method as used in Example 25, except that 3 wt. % boehmite was added as an abrasive-grain-sinking retarder. Then, the evaluation of dispersibility of the oxide abrasive grains and the CMP of an $Si_3N_4$ polycrystal were performed. The polishing slurry had abrasive grains with an average grain diameter of 0.5 $\mu$ m, a pH of 2.2, and an ORP of 1,400 mV The dispersibility of the oxide abrasive grains was 91%. The polishing rate for the $Si_3N_4$ polycrystal was as high as 4.3 $\mu$ m/hr. The surface roughness Ra of the $Si_3N_4$ polycrystal after the polishing was as extremely low as 0.6 nm. The results are summarized in Table VIII.

Example 72

A polishing slurry was prepared by the same method as used in Example 25, except that 7 wt. % boehmite was added as an abrasive-grain-sinking retarder. Then, the evaluation of dispersibility of the oxide abrasive grains and the CMP of an $Si_3N_4$ polycrystal were performed. The polishing slurry had abrasive grains with an average grain diameter of 0.5 $\mu$ m, a pH of 2.2, and an ORP of 1,400 mV The dispersibility of the oxide abrasive grains was 97%. The polishing rate for the $Si_3N_4$ polycrystal was as high as 3.3 $\mu$ m/hr. The surface roughness Ra of the $Si_3N_4$ polycrystal after the polishing was as extremely low as 0.9 nm. The results are summarized in Table VIII.

Example 73

A polishing slurry was prepared by the same method as used in Example 70, except that 2 wt. % $Al_2(SO_4)_3$ was added as the inorganic dispersant. Then, the evaluation of dispersibility of the oxide abrasive grains and the CMP of an $Si_3N_4$ polycrystal were performed. The polishing slurry had abrasive grains with an average grain diameter of 0.5

$\mu$ m, a pH of 2.2, and an ORP of 1,400 mV. The dispersibility of the oxide abrasive grains was 92%. The polishing rate for the $Si_3N_4$ polycrystal was as high as 3.9 $\mu$ m/hr. The surface roughness Ra of the $Si_3N_4$ polycrystal after the polishing was as extremely low as 0.5 nm. The results are summarized in Table VIII.

Comparative example 9

A polishing slurry was prepared by the same method as used in Example 25, except that 8 wt. % boehmite was added as an abrasive-grain-sinking retarder. Then, the evaluation of dispersibility of the oxide abrasive grains was performed. The polishing slurry had abrasive grains with an average grain diameter of 0.5 $\mu$ m, a pH of 2.2, and an ORP of 1,400 mV The dispersibility of the oxide abrasive grains was as high as 99%. However, the polishing liquid was gelatinized, so that it was impossible to perform the CMP of an $Si_3N_4$ polycrystal. The results are summarized in Table VIII.
Table I

| | | | Example | | | | | | | | | | Comparative example | |
|---|---|---|---|---|---|---|---|---|---|---|---|---|---|---|---|
| | | | 1 | 2 | 3 | 4 | 5 | 6 | 7 | 8 | 9 | 10 | 1 | 2 |
| Pol ishing slurry | Oxide abrasive grain | Type | $Al_2O_3$ | $Al_2O_3$ | $Al_2O_3$ | $Al_2O_3$ | $Al_2O_3$ | $Al_2O_3$ | $Al_2O_3$ | $Al_2O_3$ | $Al_2O_3$ | $Al_2O_3$ | $Al_2O_3$ | $Al_2O_3$ |
| | | Average grain diameter ($\mu$m) | 1 | 1 | 1 | 1 | 1 | 1 | 1 | 1 | 1 | 1 | 1 | 1 |
| | | Content (wt. %) | 5 | 5 | 5 | 5 | 5 | 5 | 5 | 5 | 5 | 5 | 5 | 5 |
| | Organic disper sant | Feature | Anion (-COOM) | Anion (-COOM) | Anion (-COOM) | Anion (-COOM) | Anion (-COOM) | Anion ($-SO_3M$) | Anion ($-SO_3M$) | Anion (($-O)_3PO$) | Cation ($R_4N+$) | Anion (-COOM) | Cation ($R_4N+$) | Nonion ($-C_2H_4O-$) |
| | | Type | PAA | PAA | PAA | PAA | PAA | NSH | NSH | HDTP | HDTMAC | PAA | HDTMAC | POE(10) |
| | | Number average molecular weight | 2,000 | 6,000 | 2,000 | 6,000 | 10,000 | 5,000 | 10,000 | 805 | 320 | 2,000 | 320 | 645 |
| | | Content (wt. %) | 0.1 | 0.1 | 0.1 | 0.1 | 0.1 | 0.1 | 0.1 | 0.1 | 0.1 | 0.1 | 0.1 | 0.1 |
| | Inorganic disper sant | Type | - | - | $Al(NO_3)_3$ | $Al(NO_3)_3$ | $Al(NO_3)_3$ | $Al(NO_3)_3$ | $Al(NO_3)_3$ | $Al(NO_3)_3$ | $Al(NO_3)_3$ | $Al(NO_3)_3$ | - | - |
| | | Content (wt. %) | - | - | 0.2 | 0.2 | 0.2 | 0.2 | 0.2 | 0.2 | 0.2 | 0.2 | - | - |
| | Oxidizing reagent | Type | DCIA | DCIA | DCIA | DCIA | DCIA | DCIA | DCIA | DCIA | DCIA | DCIA | DCIA | DCIA |
| | | Content (g/L) | 0.2 | 0.2 | 0.2 | 0.2 | 0.2 | 0.2 | 0.2 | 0.2 | 0.2 | 0.2 | 0.2 | 0.2 |
| | pH | | 5.0 | 5.0 | 4.0 | 4.0 | 4.5 | 4.5 | 4.5 | 4.5 | 4.0 | 10.0 | 5.0 | 5.0 |
| | ORP (mV) | | 1,200 | 1,200 | 1,250 | 1,250 | 1,150 | 1,150 | 1,150 | 1,150 | 1,200 | 1,150 | 1,100 | 1,100 |
| Dispersibility (%) | | | 17 | 25 | 22 | 31 | 39 | 29 | 40 | 12 | 15 | 7 | 6 | 7 |
| Polishing rate (($\mu$m/hr) | | | 3.7 | 3.3 | 3.1 | 2.8 | 2.4 | 2.9 | 2.2 | 1.2 | 0.5 | 2.6 | 0.2 | 0.3 |

(continued)

| | Example | | | | | | | | | | Comparative example | |
|---|---|---|---|---|---|---|---|---|---|---|---|---|
| | 1 | 2 | 3 | 4 | 5 | 6 | 7 | 8 | 9 | 10 | 1 | 2 |
| Surface roughness (nm) | 1.7 | 1.4 | 1.2 | 1.1 | 1.0 | 1.2 | 1.1 | 1.3 | 1.4 | 1.9 | 2.2 | 2.4 |

Note: PAA: Polyacrylic acid sodium
NSH: Condensation product of naphthalenesulfonic acid and formalin
HDTP: Hexadecyltriphosphate ester
HDTMAC: Hexadecyltrimethylammonium chloride
POE(10): Polyoxyethylene(10)octyl phenyl ether
DCIA: Dichloroisocyanuric acid sodium

Table II

| | | | Example | | | | | | | | | | | | |
|---|---|---|---|---|---|---|---|---|---|---|---|---|---|---|---|
| | | | 11 | 12 | 13 | 14 | 16 | 16 | 17 | 18 | 19 | 20 | 21 | 22 | 23 |
| Polishing slurry | Oxide abrasive grain | Type | $ZrO_2$ | $ZrO_2$ | $ZrO_2$ | $ZrO_2$ | $ZrO_2$ | $ZrO_2$ | $ZrO_2$ | $ZrO_2$ | $ZrO_2$ | $ZrO_2$ | $ZrO_2$ | $ZrO_2$ | $ZrO_2$ |
| | | Average grain diameter ((μm) | 0.5 | 0.5 | 0.5 | 0.5 | 0.5 | 0.5 | 0.5 | 0.5 | 0.5 | 0.5 | 0.5 | 0.5 | 0.5 |
| | | Content (wt. %) | 5 | 5 | 5 | 5 | 5 | 5 | 5 | 5 | 5 | 5 | 5 | 5 | 5 |
| | Organic dispersant | Feature | - | - | Anion (-COOM) | Anion (-COOM) | Anion ($-SO_3M$) | Anion ("$SO_3M$) | Anion ($-SO_3M$) | Anion ($-SO_3M$) | Anion ($-SO_3M$) | Anion ($-SO_3M$) | Anion ($-SO_3M$) | Anion ($-SO_3M$) | Anion ($-SO_3M$) |
| | | Type | - | - | PAA | PAA | NSH | NSH | NSH | NSH | NSH | NSH | NSH | NSH | NSH |
| | | Number average molecular weight | - | - | 2,000 | 6,000 | 10,000 | 10,000 | 10,000 | 10,000 | 10,000 | 10,000 | 10,000 | 10,000 | 10,000 |
| | | Content (wt. %) | - | - | 0.1 | 0.1 | 0.1 | 0.1 | 0.1 | 0.1 | 0.1 | 0.1 | 0.1 | 0.1 | 0.1 |
| | Inorganic dispersant | Type | Ca $(NO_3)_2$ | Al $(NO_3)_3$ | Ca$(NO_3)_2$ | Na$(NO_3)$ | Mg $(NO_3)_2$ | Fe$(NO_3)_2$ | Al $(NO_3)_3$ | Ni $(NO_3)_2$ | Cr $(NO_3)_3$ | Cu $(NO_3)_2$ | Zn $(NO_3)_2$ | Mn $(NO_3)_2$ | $Na_2SO_4$ |
| | | Content (wt. %) | 0.4 | 0.4 | 0.4 | 0.4 | 0.4 | 0.4 | 0.4 | 0.4 | 0.4 | 0.4 | 0.4 | 0.4 | 0.4 |
| | Oxidizing reagent | Type | DCIA | DCIA | DCIA | TCIA | DCIA | DCIA | DCIA | DCIA | DCIA | DCIA | DCIA | DCIA | DCIA |
| | | Content (g/L) | 0.2 | 0.2 | 0.2 | 0.1 | 0.4 | 0.4 | 0.4 | 0.4 | 0.4 | 0.4 | 0.4 | 0.4 | 0.4 |
| | pH | | 3.5 | 3.5 | 4.2 | 1.8 | 3.8 | 3.8 | 3.8 | 3.7 | 3.6 | 3.8 | 3.8 | 3.7 | 3.8 |
| | ORP (mV) | | 1,250 | 1,250 | 1,200 | 1,400 | 1,250 | 1,250 | 1,250 | 1,250 | 1,250 | 1,250 | 1,250 | 1,250 | 1,200 |
| Dispersibility (%) | | | 18 | 18 | 28 | 30 | 41 | 39 | 49 | 43 | 35 | 36 | 46 | 39 | 38 |
| Polishing rate (μm/hr) | | | 2.6 | 2.8 | 1.7 | 2.2 | 1.8 | 1.9 | 2.0 | 1.8 | 1.7 | 1.7 | 1.9 | 1.8 | 1.7 |

EP 2 039 474 A1

26

(continued)

| | Example | | | | | | | | | | | | |
|---|---|---|---|---|---|---|---|---|---|---|---|---|---|
| | 11 | 12 | 13 | 14 | 16 | 16 | 17 | 18 | 19 | 20 | 21 | 22 | 23 |
| Surface roughness (nm) | 1.8 | 1.7 | 0.9 | 0.7 | 0.8 | 0.7 | 0.7 | 0.7 | 0.6 | 0.6 | 0.7 | 0.7 | 0.6 |

Note: PAA: Polyacrylic acid sodium
NSH: Condensation product of naphthalenesulfonic acid and formalin
DCIA: Dichloroisocyanuric acid sodium
TCIA: Trichloroisocyanuric acid sodium

Table III

| | | | Example | | | | | | | | | |
|---|---|---|---|---|---|---|---|---|---|---|---|---|
| | | | 24 | 25 | 26 | 27 | 28 | 29 | 30 | 31 | 32 | 33 |
| Polishing slurry | Oxide abrasive grain | Type | $ZrO_2$ | $Cr_2O_3$ | $Cr_2O_3$ | $Cr_2O_3$ | $Cr_2O_3$ | $Cr_2O_3$ | $Cr_2O_3$ | $Cr_2O_3$ | $Al_2O_3$ | $Al_2O_3$ |
| | | Average grain diameter ($\mu$m) | 0.5 | 0.5 | 0.5 | 0.5 | 0.5 | 0.5 | 0.5 | 0.5 | 0.5 | 0.5 |
| | | Content (wt. %) | 5 | 5 | 5 | 5 | 5 | 5 | 5 | 5 | 5 | 5 |
| | Organic dispersant | Feature | Anion ($-SO_3M$) | Anion ($-SO_3M$) | Anion ($-SO_3M$) | Anion ($-SO_3M$) | Anion ($-SO_3M$) | Anion ($-SO_3M$) | Anion ($-SO_3M$) | Anion ($-SO_3M$) | Anion ($(-O)_3PO)$) | Anion ($(-O)_3PO)$) |
| | | Type | NSH | NSH | NSH | NSH | NSH | NSH | NSH | NSH | HDTP | HDTP |
| | | Number average molecular weight | 5,000 | 10,000 | 10,000 | 10,000 | 10,000 | 10,000 | 10,000 | 10,000 | 805 | 805 |
| | | Content (wt. %) | 0.1 | 0.1 | 0.1 | 0.1 | 0.1 | 0.1 | 0.1 | 0.1 | 0.1 | 0.1 |
| | Inorganic disper sant | Type | $MgSO_4$ | $Al_2(SO_4)_3$ | $NiSO_4$ | $Cr_2(SO_4)_3$ | $CuSO_4$ | $FeSO_4$ | $ZnSO_4$ | $MnSO_4$ | $NaHCO_3$ | $Na_2CO_3$ |
| | | Content (wt. %) | 0.4 | 0.4 | 0.4 | 0.4 | 0.4 | 0.4 | 0.4 | 0.4 | 0.4 | 0.4 |
| | Oxidizing reagent | Type | $H_2O_2$ | TCIA | TCIA | TCIA | TCIA | TCIA | TCIA | TCIA | $H_2O_2$ | $H_2O_2$ |
| | | Content (g/L) | 2.0 | 0.1 | 0.1 | 0.1 | 0.1 | 0.1 | 0.1 | 0.1 | 2.0 | 2.0 |
| | pH | | 4.0 | 2.2 | 2.2 | 2.2 | 2.2 | 2.2 | 2.2 | 2.2 | 4.5 | 4.5 |
| | ORP (mV) | | 750 | 1,400 | 1,400 | 1,400 | 1,400 | 1,400 | 1,400 | 1,400 | 700 | 700 |
| Dispersibility (%) | | | 30 | 40 | 39 | 36 | 41 | 40 | 40 | 39 | 13 | 14 |
| Polishing rate ($\mu$m/hr) | | | 0.9 | 3.0 | 2.9 | 2.8 | 2.8 | 2.7 | 2.9 | 2.8 | 0.6 | 0.6 |

29

(continued)

| | Example | | | | | | | | | |
|---|---|---|---|---|---|---|---|---|---|---|
| | 24 | 25 | 26 | 27 | 28 | 29 | 30 | 31 | 32 | 33 |
| Surface roughness (nm) | 1.4 | 1.0 | 1.0 | 0.9 | 0.9 | 1.0 | 1.0 | 0.9 | 0.6 | 0.6 |

Note: NSH: Condensation product of naphthalenesulfonic acid and formalin
HDTP: Hexadecyltriphosphate ester
TCIA: Trichloroisocyanuric acid sodium

Table IV

| | | | Example | | | | | | | | | | | Comparative example | |
|---|---|---|---|---|---|---|---|---|---|---|---|---|---|---|---|---|
| | | | 34 | 35 | 36 | 37 | 38 | 39 | 40 | 41 | 42 | 43 | 3 | 4 |
| Polishing slurry | Oxide abrasive grain | Type | $ZrO_2$ | $ZrO_2$ | $ZrO_2$ | $ZrO_2$ | $ZrO_2$ | $ZrO_2$ | $ZrO_2$ | $ZrO_2$ | $ZrO_2$ | $ZrO_2$ | $ZrO_2$ | $Cr_2O_2$ |
| | | Average grain diameter ($\mu$m) | 0.5 | 0.5 | 0.5 | 0.5 | 0.5 | 0.5 | 0.5 | 0.5 | 0.5 | 0.5 | 0.5 | 1 |
| | | Content (wt. %) | 5 | 5 | 5 | 5 | 5 | 5 | 5 | 5 | 5 | 5 | 5 | 5 |
| | Organic disper sant | Feature | Anion $((-O)_3PO)$ | Anion $((-O)_3PO)$ | Anion $((-O)_3PO)$ | Anion $((-O)_3PO)$ | Anion $((-O)_3PO)$ | Anion $((-O)_3PO)$ | Anion $((-O)_3PO)$ | Anion $((-O)_3PO)$ | Anion $((-O)_3PO)$ | Anion $((-O)_3PO)$ | Cation $(R_4N+)$ | Nonion $(-C_2H_4O-)$ |
| | | Type | HDTP | HDTP | HDTP | HDTP | HDTP | HDTP | HDTP | HDTP | HDTP | HDTP | HDTMAC | POE(10) |
| | | Number average molecular weight | 805 | 805 | 805 | 805 | 805 | 805 | 805 | 805 | 805 | 805 | 320 | 645 |
| | | Content (wt. %) | 0.1 | 0.1 | 0.1 | 0.1 | 0.1 | 0.1 | 0.1 | 0.1 | 0.1 | 0.1 | 0.1 | 0.1 |
| | Inorganic disper sant | Type | $Na_3PO_4$ | $CaCl_2$ | NaCl | $AlCl_3$ | $MgCl_2$ | $NiCl_2$ | $CuCl_2$ | $FeCl_2$ | $ZnCl_2$ | $MnCl_2$ | - | - |
| | | Content (wt. %) | 0.4 | 0.4 | 0.4 | 0.4 | 0.4 | 0.4 | 0.4 | 0.4 | 0.4 | 0.4 | - | - |
| | Oxidizing reagent | Type | TCIA | TCIA | TCIA | TCIA | TCIA | TCIA | TCIA | TCIA | TCIA | TCIA | DCIA | TCIA |
| | | Content (g/L) | 0.1 | 0.1 | 0.1 | 0.1 | 0.1 | 0.1 | 0.1 | 0.1 | 0.1 | 0.1 | 0.4 | 0.1 |
| | pH | | 2.5 | 2.5 | 2.5 | 2.5 | 2.5 | 2.5 | 2.5 | 2.5 | 2.5 | 2.5 | 2.5 | 2.5 |
| | ORP (mV) | | 1,350 | 1,350 | 1,350 | 1,350 | 1,350 | 1,350 | 1,350 | 1,350 | 1,350 | 1,350 | 1,350 | 1,350 |
| Dispersibility (%) | | | 14 | 13 | 14 | 14 | 14 | 15 | 14 | 14 | 13 | 14 | 6 | 8 |
| Polishing rate ($\mu$m/hr) | | | 0.9 | 0.9 | 0.8 | 0.9 | 0.8 | 0.8 | 0.9 | 0.8 | 0.9 | 0.9 | 0.1 | 0.2 |

(continued)

| | Example | | | | | | | | | | Comparative example | |
|---|---|---|---|---|---|---|---|---|---|---|---|---|
| | 34 | 35 | 36 | 37 | 38 | 39 | 40 | 41 | 42 | 43 | 3 | 4 |
| Surface roughness (nm) | 0.8 | 0.8 | 0.8 | 0.8 | 0.9 | 0.8 | 0.8 | 0.8 | 0.9 | 0.8 | 2.4 | 2.3 |

Note: HDTP: Hexadecyltriphosphate ester
HDTMAC: Hexadecyltrimethylammonium chloride
POE(10): Polyoxyethylene(10)octyl phenyl ether
TCIA: Trichloroisocyanuric acid sodium
DCIA: Dichloroisocyanuric acid sodium

Table V

| | | | Example | | | | | | | | | | | | Comparative example | |
|---|---|---|---|---|---|---|---|---|---|---|---|---|---|---|---|---|
| | | | 44 | 45 | 46 | 47 | 48 | 49 | 50 | 51 | 52 | 53 | 54 | 55 | 5 | 6 |
| Polishing slurry | Oxide abrasive grain | Type | $Al_2O_3$ | $Cr_2O_3$ | $Fe_2O_3$ | $ZrO_2$ | $TiO_2$ | NiO | $SiO_2$ | $Al_2O_3$ | $Cr_2O_3$ | $Fe_3O_4$ | CuO | $MnO_2$ | $Al_2O_3$ | $ZrO_2$ |
| | | Average grain diameter ($\mu$m) | 0.5 | 1 | 0.5 | 0.3 | 0.1 | 0.5 | 0.2 | 2 | 2 | 0.5 | 0.5 | 0.5 | 0.5 | 0.5 |
| | | Content (wt. %) | 10 | 10 | 10 | 5 | 10 | 5 | 10 | 10 | 5 | 10 | 5 | 5 | 5 | 5 |
| | Organic dispersant | Feature | Anion ($-COOM$) | Anion ($-COOM$) | Anion ($-COOM$) | Anion ($-SO_3M$) | Anion ($-SO_3M$) | Anion ($(-O)_3PO$) | Anion ($(-O)_3PO$) | Anion ($-COOM$) | Anion ($-COOM$) | Anion ($-COOM$) | Anion ($-COOM$) | Anion ($-COOM$) | Anion ($-SO_3m$) | Anion ($(-O)_3PO$) |
| | | Type | PAA | PAA | PAA | NSH | NSH | HDTP | HDTP | PAA | PAA | PAA | PAA | PAA | NSH | HDTP |
| | | Number average molecular weight | 2,000 | 6,000 | 6,000 | 5,000 | 10,000 | 805 | 805 | 35,000 | 35,000 | 35,000 | 35,000 | 35,000 | 10,000 | 805 |
| | | Content (wt. %) | 0.1 | 0.1 | 0.1 | 0.1 | 0.1 | 0.1 | 0.1 | 0.1 | 0.1 | 0.1 | 0.1 | 0.1 | 0.1 | 0.1 |
| | Inorganic dispersant | Type | $NaNO_3$ | $NaNO_3$ | $NaNO_3$ | $NaNO_3$ | $NaNO_3$ | $NaNO_3$ | $NaNO_3$ | $NaNO_3$ | $NaNO_3$ | $NaNO_3$ | $NaNO_3$ | $NaNO_3$ | $NaNO_{33}$ | $NaNO_3$ |
| | | Content (wt. %) | 0.4 | 0.4 | 0.4 | 0.4 | 0.4 | 0.4 | 0.4 | 0.4 | 0.4 | 0.4 | 0.4 | 0.4 | 0.4 | 0.4 |
| | Oxidizing reagent | Type | TCIA | TCIA | TCIA | TCIA | TCIA | TCIA | TCIA | TCIA | TCIA | TCIA | TCIA | TCIA | - | - |
| | | Content (g/L) | 0.1 | 0.1 | 0.1 | 0.1 | 0.1 | 0.1 | 0.1 | 0.1 | 0.1 | 0.1 | 0.1 | 0.1 | - | - |
| | pH | | 1.8 | 2.5 | 2.5 | 2.5 | 2.5 | 2.5 | 2.5 | 3.0 | 3.0 | 3.0 | 3.0 | 3.0 | 4.5 | 4.5 |
| | ORP (mV) | | 1,400 | 1,350 | 1,350 | 1,350 | 1,350 | 1,350 | 1,350 | 1,000 | 1,000 | 1,000 | 1,000 | 1,000 | 700 | 700 |
| Dispersibility (%) | | | 40 | 55 | 61 | 27 | 88 | 12 | 29 | 91 | 46 | 90 | 48 | 52 | 50 | 14 |
| Polishing rate ($\mu$m/hr) | | | 3.4 | 3.3 | 0.8 | 1.5 | 0.6 | 1.3 | 0.4 | 2.8 | 2.7 | 0.8 | 0.5 | 0.9 | 0.2 | 0.1 |
| Surface roughness (nm) | | | 1.1 | 1.0 | 0.3 | 0.6 | 0.4 | 0.5 | 0.4 | 1.6 | 1.5 | 0.4 | 0.3 | 0.4 | 2.1 | 1.9 |

Note: PAA: Polyacrylic acid sodium
NSH: Condensation product of naphthalenesulfonic acid and formalin
HDTP: Hexadecyltriphosphate ester
TCIA: Trichloroisocyanuric acid sodium

Table VI

| | | Example | | | | | | Comparative example |
|---|---|---|---|---|---|---|---|---|
| | | 56 | 57 | 58 | 59 | 60 | 61 | 7 |
| Oxide abrasive grain | Type | $Al_2O_3$ | $Al_2O_3$ | $Al_2O_3$ | $Al_2O_3$ | $Al_2O_3$ | $Al_2O_3$ | $Al_2O_3$ |
| | Average grain diameter | 1 | 1 | 1 | 1 | 1 | 1 | 1 |
| | Content (wt. %) | 5 | 5 | 5 | 5 | 5 | 5 | 5 |
| Organic dispersant | Feature | Anion (-COOM) | Anion (-COOM) | Anion (-COOM) | Anion (-COOM) | Anion (-COOM) | Anion (-COOM) | Anion (-COOM) |
| | Type | PAA | PAA | PAA | PAA | PAA | PAA | PAA |
| | Average molecular weight | 2,000 | 2,000 | 2,000 | 2,000 | 2,000 | 2,000 | 2,000 |
| | Content (wt. %) | 0.1 | 0.1 | 0.1 | 0.1 | 0.1 | 0.1 | 0.1 |
| Inorganic dispersant | Type | $Al(NO_3)_3$ | $Al(NO_3)_3$ | $Al(NO_3)_3$ | $Al(NO_3)_3$ | $Al(NO_3)_3$ | $Al(NO_3)_3$ | $Al(NO_3)_3$ |
| | Content (wt. %) | 0.2 | 0.2 | 0.2 | 0.2 | 0.2 | 2 | 0.2 |
| Sinking retarder | Boehmite (wt. %) | 0.1 | 1 | 2 | 3 | 7 | 2 | 8 |
| Oxidizing reagent | Type | DCIA | DCIA | DCIA | DCIA | DCIA | DCIA | DCIA |
| | Content (g/L) | 0.2 | 0.2 | 0.2 | 0.2 | 0.2 | 0.2 | 0.2 |
| pH | | 4 | 4 | 4 | 4 | 4 | 4 | 4 |
| CORP (mV) | | 1,250 | 1,250 | 1,250 | 1,250 | 1,250 | 1,250 | 1,250 |
| Dispersibility (%) | | 31 | 49 | 62 | 75 | 96 | 84 | 98 |
| Polishing rate (μm/hr) | | 3.2 | 3.7 | 4.1 | 4.5 | 3.4 | 3.9 | |
| Surface roughness (nm) | | 1.1 | 0.9 | 0.8 | 0.7 | 1.1 | 0.6 | |
| Remarks | | | | | | | | Gelatinized |

Table VII

| | | Example | | | | | | Comparative example |
|---|---|---|---|---|---|---|---|---|
| | | 62 | 63 | 64 | 65 | 66 | 67 | 8 |
| Oxide abrasive grain | Type | $ZrO_2$ | $ZrO_2$ | $ZrO_2$ | $ZrO_2$ | $ZrO_2$ | $ZrO_2$ | $ZrO_2$ |
| | Average grain diameter | 0.5 | 0.5 | 0.5 | 0.5 | 0.5 | 0.5 | 0.5 |
| | Content (wt. %) | 5 | 5 | 5 | 5 | 5 | 5 | 5 |
| Organic dispersant | Feature | Anion (-COOM) | Anion (-COOM) | Anion (-COOM) | Anion (-COOM) | Anion (-COOM) | Anion (-COOM) | Anion (-COOM) |
| | Type | PAA | PAA | PAA | PAA | PAA | PAA | PAA |
| | Average molecular weight | 6,000 | 6,000 | 6,000 | 6,000 | 6,000 | 6,000 | 6,000 |
| | Content (wt. %) | 0.1 | 0.1 | 0.1 | 0.1 | 0.1 | 0.1 | 0.1 |
| Inorganic dispersant | Type | $NaNO_3$ | $NaNO_3$ | $NaNO_3$ | $NaNO_3$ | $NaNO_3$ | $NaNO_3$ | $NaNO_3$ |
| | Content (wt. %) | 0.4 | 0.4 | 0.4 | 0.4 | 0.4 | 2 | 0.4 |
| Sinking retarder | Boehmite (wt. %) | 0.1 | 1 | 2 | 3 | 7 | 2 | 8 |
| Oxidizing reagent | Type | TCIA | TCIA | TCIA | TCIA | TCIA | TCIA | TCIA |
| | Content (g/L) | 0.1 | 0.1 | 0.1 | 0.1 | 0.1 | 0.1 | 0.1 |
| pH | | 1.8 | 1.8 | 1.8 | 1.8 | 1.8 | 1.8 | 1.8 |
| ORP (mV) | | 1,400 | 1,400 | 1,400 | 1,400 | 1,400 | 1,400 | 1,400 |
| Dispersibility (%) | | 39 | 53 | 69 | 83 | 97 | 90 | 99 |
| Polishing rate ($\mu$m/hr) | | 2.3 | 2.6 | 2.9 | 3.2 | 2.5 | 2.8 | |
| Surface roughness (nm) | | 0.6 | 0.5 | 0.5 | 0.4 | 0.6 | 0.3 | |
| Remarks | | | | | | | | Gelatinized |

Table VIII

| | | Example | | | | | | Comparative example |
|---|---|---|---|---|---|---|---|---|
| | | 68 | 69 | 70 | 71 | 72 | 73 | 9 |
| Oxide abrasive grain | Type | $Cr_2O_3$ | $Cr_2O_3$ | $Cr_2O_3$ | $Cr_2O_3$ | $Cr_2O_3$ | $Cr_2O_3$ | $Cr_2O_3$ |
| | Average grain diameter | 0.5 | 0.5 | 0.5 | 0.5 | 0.5 | 0.5 | 0.5 |
| | Content (wt. %) | 5 | 5 | 5 | 5 | 5 | 5 | 5 |

(continued)

| | | Example | | | | | | Comparative example |
|---|---|---|---|---|---|---|---|---|
| | | 68 | 69 | 70 | 71 | 72 | 73 | 9 |
| Organic dispersant | Feature | Anion (-SO$_3$M) | Anion (-SO$_3$M) | Anion (-SO$_3$M) | Anion (-SO$_3$M) | Anion (-SO$_3$M) | Anion (-SO$_3$M) | Anion (-SO$_3$M) |
| | Type | NSH | NSH | NSH | NSH | NSH | NSH | NSH |
| | Average molecular weight | 10,000 | 10,000 | 10,000 | 10,000 | 10,000 | 10,000 | 10,000 |
| | Content (wt. %) | 0.1 | 0.1 | 0.1 | 0.1 | 0.1 | 0.1 | 0.1 |
| Inorganic dispersant | Type | Al$_2$(SO$_4$)$_3$ | Al$_2$(SO$_4$)$_3$ | Al$_2$(SO$_4$)$_3$ | Al$_2$(SO$_4$)$_3$ | Al$_2$(SO$_4$)$_3$ | Al$_2$(SO$_4$)$_3$ | Al$_2$(SO$_4$)$_3$ |
| | Content (wt. %) | 0.4 | 0.4 | 0.4 | 0.4 | 0.4 | 2 | 0.4 |
| Sinking retarder | Boehmite (wt. %) | 0.1 | 1 | 2 | 3 | 7 | 2 | 8 |
| Oxidizing reagent | Type | TCIA | TCIA | TCIA | TCIA | TCIA | TCIA | TCIA |
| | Content (g/L) | 0.1 | 0.1 | 0.1 | 0.1 | 0.1 | 0.1 | 0.1 |
| pH | | 2.2 | 2.2 | 2.2 | 2.2 | 2.2 | 2.2 | 2.2 |
| ORP (mV) | | 1,400 | 1,400 | 1,400 | 1,400 | 1,400 | 1,400 | 1,400 |
| Dispersibility (%) | | 47 | 65 | 81 | 91 | 97 | 92 | 99 |
| Polishing rate ($\mu$m/hr) | | 3.1 | 3.7 | 4.1 | 4.3 | 3.3 | 3.9 | |
| Surface roughness (nm) | | 0.9 | 0.8 | 0.7 | 0.6 | 0.9 | 0.5 | |
| Remarks | | | | | | | | Gelatinized |

In Table I , Examples 1 and 2 show that the dispersibility is high even without the addition of the inorganic dispersant. The likely reason is that the anionic organic dispersant covering the oxide abrasive grains functions as a cushion, so that the oxide abrasive grains are separated from one another.

In Table I , Examples 3 to 5 show that as PAA, which is an anionic organic dispersant having a -COOH group, increases its number average molecular weight or increases its content, the dispersibility increases but the polishing rate for the Si$_3$N$_4$ polycrystal is decreased. The probable cause of this is that as the quantity of the dispersant covering the oxide abrasive grains increases, the dispersibility in an aqueous liquid is increased but the polishing ability of the surface of the abrasive grains is decreased. Conversely, as PAA, which is an anionic organic dispersant having a -COOH group, decreases its number average molecular weight or decreases its content, the dispersibility decreases but the polishing rate for the Si$_3$N$_4$ polycrystal is increased.

In Table II, Examples 11 and 12 show that even when no anionic organic dispersant is added, the dispersibility is high. This is attributable to the fact that because the pH of the slurry is not higher than the isoelectric point, the surface of the oxide abrasive grains is positively charged, so that the repulsive force separated the oxide abrasive grains from one another.

As shown in Tables I to V, when the oxide abrasive grains is any one of TiO$_2$, Fe$_2$O$_3$, Fe$_3$O$_4$, NiO, CuO, MnO$_2$, Cr$_2$O$_3$, SiO$_2$, Al$_2$O$_3$, and ZrO$_2$, a desirable polishing slurry is obtained.

In Table I , Example 9 and Comparative examples 1 and 2 show that when a cationic organic dispersant or a nonionic organic dispersant is used as the dispersant, the abrasive grains have a low dispersibility, so that a desirable polishing slurry cannot be obtained.

In Table I , Examples 3 and 9 show that even in the case where both an anionic organic dispersant and an inorganic dispersant are present in the polishing slurry, when the pH is higher than the isoelectric point, a suspendible substance is not formed, so that the dispersibility of the abrasive grains is lower than that when the pH is lower than the isoelectric point.

As shown in Tables VI to VIII, when the polishing slurry contains boehmite as a sinking retarder, a polishing slurry having an increased dispersibility can be obtained. However, in Comparative examples 7 to 9, the polishing slurry is gelatinized. Therefore, it is desirable that the polishing slurry have a boehmite content of at least 0.1 wt. % and less than 8 wt. %, more desirably at least 1 wt. % and at most 3 wt. % in order to increase the dispersibility of the polishing slurry and to produce a polishing slurry that suppresses an excessive increase in the viscosity. When the above condition is satisfied, a desirable polishing slurry or a more desirable polishing slurry can be obtained.

It is to be considered that the above-disclosed embodiments and examples are illustrative and not restrictive in all respects. The scope of the present invention is shown by the scope of the appended claims, not by the above-described explanations. Accordingly, the present invention is intended to cover all revisions and modifications included within the meaning and scope equivalent to the scope of the claims.

Industrial applicability

The method of the present invention for producing a polishing slurry enables the production of a polishing slurry to be used suitably for the polishing of the surface of a nitride crystal. The polishing slurry of the present invention contains at least one dispersant selected from the group consisting of an anionic organic dispersant and an inorganic dispersant, so that oxide abrasive grains are stably dispersed. This feature enables a stable and efficient polishing of a crystal for forming a wafer to be used as a substrate of a semiconductor device.

**Claims**

1. A polishing slurry for polishing the surface of a nitride crystal, the polishing slurry comprising oxide abrasive grains, at least one dispersant selected from the group consisting of an anionic organic dispersant and an inorganic dispersant, and an oxidizing reagent;
the polishing slurry having a pH of less than 7.

2. The polishing slurry as defined by claim 1, wherein the at least one dispersant is both an anionic organic dispersant and an inorganic dispersant.

3. The polishing slurry as defined by claim 1 or 2, wherein the oxide abrasive grains have an isoelectric point higher than the pH of the polishing slurry.

4. The polishing slurry as defined by any of claims 1 to 3, wherein the oxide abrasive grains are composed of at least one type of oxide selected from the group consisting of $Ti_2O$, $Fe_2O_3$, $Fe_3O_4$, $NiO$, $CuO$, $Cr_2O_3$, $SiO_2$, $Al_2O_3$, $MnO_2$, and $ZrO_2$.

5. The polishing slurry as defined by any of claims 1 to 4, wherein the anionic organic dispersant has a -COOM group ("M" stands for H, $NH_4$, or a metallic element).

6. The polishing slurry as defined by any of claims 1 to 4, wherein the inorganic dispersant is at least one member selected from the group consisting of $Ca(NO_3)_2$, $NaNO_3$, $Al(NO_3)_3$, $Mg(NO_3)_2$, $Ni(NO_3)_2$, $Cr(NO_3)_3$, $Cu(NO_3)_2$, $Fe(NO_3)_2$, $Zn(NO_3)_2$, $Mn(NO_3)_2$, $Na_2SO_4$, $Al_2(SO_4)_3$, $MgSO_4$, $NiSO_4$, $Cra(SO_4)_3$, $CuSO_4$, $FeSO_4$, $ZnSO_4$, $MnSO_4$, $Na_2CO_3$, $NaHCO_3$, $Na_3PO_4$, $CaCl_2$, $NaCl$, $AlCh_3$, $MgCl_2$, $NiCl_2$, $CuCl_2$, $FeCl_2$, $ZnCl_2$, and $MnCl_2$.

7. The polishing slurry as defined by any of claims 1 to 6, the polishing slurry further comprising a sinking retarder composed of boehmite.

8. A method of producing the polishing slurry as defined by any of claims 1 to 7, the method comprising the steps of:

   (a) first, adding to an aqueous liquid at least the oxide abrasive grains and at least one dispersant selected from the group consisting of the anionic organic dispersant and the inorganic dispersant; and
   (b) then, mechanically dispersing the oxide abrasive grains.

9. A method of polishing the surface of a nitride crystal, the method performing the polishing of the surface of the nitride crystal chemomechanically by using the polishing slurry as defined by any of claims 1 to 7.

**10.** A nitride crystal, being obtained through the method as defined by claim 9 and having a surface roughness, Ra, of at most 2 nm.

FIG. 1A

FIG. 1B

FIG. 2

<table>
<tr><td colspan="2">**INTERNATIONAL SEARCH REPORT**</td><td>International application No.<br>PCT/JP2008/052303</td></tr>
</table>

A. CLASSIFICATION OF SUBJECT MATTER
*B24B37/00*(2006.01)i, *C09K3/14*(2006.01)i, *H01L21/304*(2006.01)i

According to International Patent Classification (IPC) or to both national classification and IPC

B. FIELDS SEARCHED

Minimum documentation searched (classification system followed by classification symbols)
B24B37/00, C09K3/14, H01L21/304

Documentation searched other than minimum documentation to the extent that such documents are included in the fields searched
Jitsuyo Shinan Koho          1922-1996   Jitsuyo Shinan Toroku Koho   1996-2008
Kokai Jitsuyo Shinan Koho    1971-2008   Toroku Jitsuyo Shinan Koho   1994-2008

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2005-123577 A  (Rohm and Haas Electronic Materials CMP Holdings, Inc.), 12 May, 2005 (12.05.05), Full text; all drawings & US 2005/0029491 A1   & EP 1505134 A1 & KR 10-2005-0016171 A  & CN 1590487 A | 1,3-5,8-9 |
| Y | JP 2006-310362 A  (Sumitomo Electric Industries, Ltd.), 09 November, 2006 (09.11.06), Full text; all drawings & US 2006/0236922 A1   & EP 1717286 A1 & KR 10-2006-0112232 A  & CN 1868674 A | 1-10 |

[X] Further documents are listed in the continuation of Box C.    [ ] See patent family annex.

| | |
|---|---|
| * Special categories of cited documents:<br>"A" document defining the general state of the art which is not considered   to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>13 May, 2008 (13.05.08) | Date of mailing of the international search report<br>27 May, 2008 (27.05.08) |
|---|---|
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

International application No.

PCT/JP2008/052303

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2001-342456 A  (Praxair S.T. Technology Inc.),<br>14 December, 2001 (14.12.01),<br>Par. Nos. [0032] to [0034]; table 3<br>& US 6299795 B1        & US 6491837 B1<br>& EP 1118647 A1        & CN 1333317 A | 1-10 |
| Y | JP 1-205973 A  (Mitsubishi Kasei Corp.),<br>18 August, 1989 (18.08.89),<br>Full text; all drawings<br>& US 4956015 A          & EP 325232 A2<br>& DE 68927116 C        & DE 68927116 T<br>& KR 10-0141694 B | 1-10 |

Form PCT/ISA/210 (continuation of second sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003306669 A

- JP 2001035819 A